# EUROPÄISCHE PATENTSCHRIFT

(11) **EP 4 249 847 B1**
(45) Veröffentlichungstag und Bekanntmachung des Hinweises auf die Patenterteilung: **10.09.2025**
(21) Anmeldenummer: 23186434.9
(22) Anmeldetag: 08.04.2019
(51) Int. Cl.: G01B 11/00, G01B 5/008

(54) **VERFAHREN UND COMPUTEREINRICHTUNG ZUM AUSWÄHLEN EINER MESSREIHENFOLGE FÜR EIN KOORDINATENMESSGERÄT**
METHOD AND COMPUTER DEVICE FOR SELECTING A SEQUENCE OF MEASUREMENTS FOR A COORDINATE MEASURING DEVICE
PROCÉDÉ ET DISPOSITIF INFORMATIQUE PERMETTANT DE SÉLECTIONNER UNE SÉQUENCE DE MESURE POUR UN APPAREIL DE MESURE DE COORDONNÉES

(43) Veröffentlichungstag der Anmeldung: 27.09.2023
(62) Teilanmeldung aus: 19167949.7
(73) Patentinhaber: Carl Zeiss Industrielle Messtechnik GmbH, 73447 Oberkochen (DE)
(72) Erfinder: Frank, Jonas, 74597 Stimpfach (DE)
(74) Vertreter: Patentanwälte Bressel und Partner mbB

(56) Entgegenhaltungen:
- US-A- 5 465 221
- RAAD SALMAN ET AL: "An Industrially Validated CMM Inspection Process with Sequence Constraints", PROCEDIA CIRP, vol. 44, no. 44, 1 January 2016 (2016-01-01), NL, pages 138 - 143, XP055625914, ISSN: 2212-8271, DOI: 10.1016/j.procir.2016.02.136
- HAN ZHENHUA ET AL: "A 3D measuring path planning strategy for intelligent CMMs based on an improved ant colony algorithm", THE INTERNATIONAL JOURNAL OF ADVANCED MANUFACTURING TECHNOLOGY, SPRINGER, LONDON, vol. 93, no. 1, 16 June 2017 (2017-06-16), pages 1487 - 1497, XP036339667, ISSN: 0268-3768, [retrieved on 20170616], DOI: 10.1007/S00170-017-0503-Y
- HAN Z ET AL: "Path planning method for intelligent CMMs based on safety and the high-efficiency principle", INTERNATIONAL JOURNAL OF ADVANCED MANUFACTURING TECHNOLOGY 20180401 SPRINGER LONDON GBR, vol. 95, no. 9-12, 1 April 2018 (2018-04-01), pages 4003 - 4012, XP002794603, DOI: 10.1007/S00170-017-1500-X
- QU L ET AL: "Optimization of the measuring path on a coordinate measuring machine using genetic algorithms", MEASUREMENT, INSTITUTE OF MEASUREMENT AND CONTROL. LONDON, GB, vol. 23, no. 3, 1 April 1998 (1998-04-01), pages 159 - 170, XP004149400, ISSN: 0263-2241, DOI: 10.1016/S0263-2241(98)00023-2
- ZHAO F ET AL: "Computer-Aided Inspection Planning-The state of the art", COMPUTERS IN INDUSTRY, ELSEVIER, AMSTERDAM, NL, vol. 60, no. 7, 1 September 2009 (2009-09-01), pages 453 - 466, XP026148403, ISSN: 0166-3615, [retrieved on 20090305], DOI: 10.1016/J.COMPIND.2009.02.002
- LI Y ET AL: "Free-form surface inspection techniques state of the art review", COMPUTER AIDED DESIGN, ELSEVIER PUBLISHERS BV., BARKING, GB, vol. 36, no. 13, 1 November 2004 (2004-11-01), pages 1395 - 1417, XP004534040, ISSN: 0010-4485, DOI: 10.1016/J.CAD.2004.02.009

## Beschreibung

Die Erfindung betrifft Verfahren und eine Computereinrichtungen zum Festlegen einer Messreihenfolge für ein Koordinatenmessgerät.

Beim Vermessen eines Objekts mit einem Koordinatenmessgerät arbeitet das Koordinatenmessgerät in der Regel einer Reihe von Vermessungsvorgängen ab. Die Vermessungsvorgänge dienen dazu, vorbestimmte Eigenschaften, insbesondere vorbestimmte geometrische Eigenschaften, von Oberflächenbereichen des Objekts zu bestimmen. Im Rahmen eines Vermessungsvorgangs ermittelt das Koordinatenmessgerät die räumlichen Koordinaten von Punkten an der Objektoberfläche bzw. in dem Oberflächenbereich, woraus dann auf die vorbestimmte Eigenschaft geschlossen werden kann. Beispiele für derartige Eigenschaften, die auch als Prüfmerkmal bezeichnet werden, sind eine Rundheit, eine Parallelität, eine Ebenheit oder einer Oberflächenrauheit.

Die Oberflächenbereiche können hingegen bestimmten geometrischen Merkmalen des Objekts zugeordnet sein oder, mit anderen Worten, durch diese gebildet werden oder diese umfassen. Die Oberflächenbereiche können allgemein als Messelemente bezeichnet werden. Beispiele derartiger Oberflächenbereiche sind ein Zylinder (z.B. in Form einer Bohrung, einer Nut oder eines Vorsprungs), ein Kreis, eine Kugel oder ein Punkt.

Eine Möglichkeit zum Festlegen einer Messreihenfolge, gemäß derer ein gegebenes Objekt vermessen werden soll, besteht darin, die relevanten geometrischen Merkmale bzw. Oberflächenbereiche oder, allgemein ausgedrückt, Messelemente auszuwählen, die vermessen werden sollen. Insbesondere kann für jedes Messelement angegeben werden, welche Eigenschaften (d. h. welche Prüfmerkmale) hiervon vermessen und dadurch bestimmt werden sollen. Die Eigenschaften können auch relativ zu und/oder in Bezug auf ein weiteres Messelement bestimmt werden, z.B. als Distanz oder Winkel eines Messelements zu einem weiteren Messelement. Derartige Festlegungen können anhand eines CAD-Modells des Objekts erfolgen.

Beispielsweise kann ein Bediener als Oberflächenbereich bzw. Messelement eine Bohrung des Objekts auswählen und angeben, dass hiervon als Eigenschaften der Durchmesser und die Tiefe bestimmt werden soll. Ebenso kann er als Oberflächenbereich einen Vorsprung auswählen und angeben, dass hiervon als Eigenschaft die Höhe bestimmt werden soll. Auf diese Weise kann eine Mehrzahl entsprechender Oberflächenbereiche und bei komplexen Bauteilen auch eine große Vielzahl von Oberflächenbereichen samt hierfür jeweils zu bestimmender Eigenschaften ermittelt werden. Anders ausgedrückt kann sich die von einem Koordinatenmessgerät zu bewerkstelligende Vermessungsaufgabe für ein Objekt aus zahlreichen Messelementen samt hierfür jeweils zu vermessender Prüfmerkmale zusammensetzen.

Zum Vermessen der Oberflächenbereiche ist an dem Koordinatenmessgerät in an sich bekannter Weise ein Messsensor angebracht. Dieser kann taktil (d. h. mit einem taktilen Taster) oder berührungslos arbeiten (zum Beispiel wenn er als optischer Sensor ausgebildet ist, bspw. als Kamera und/oder als optischer Abstandsensor). Zum Vermessen der Oberflächenbereiche ist dieser Messsensor von dem Koordinatenmessgerät in wenigstens einer vorbestimmten Position und/oder mit einer vorbestimmten Ausrichtung anzuordnen. Die Position und/oder Ausrichtung können sich aus dem Erfordernis des Einnehmens einer entsprechenden Relativanordnung zu dem Objekt ergeben, um eine gewünschte Eigenschaft bestimmen zu können. Zum Beispiel kann hierdurch dann ein bestimmter Punkt an der Oberfläche des Objekts angetastet oder ein Bereich mit mehreren Punkten abgebildet werden.

Die Oberflächenbereiche können relativ zueinander beabstandet sein, d. h. voneinander getrennt und/oder zumindest nicht vollständig überlappend an dem Objekt positioniert sein. Sie können sich aber auch zumindest teilweise überlappen. Zum Erreichen der jeweiligen Oberflächenbereiche und/oder zumindest zum Einnehmen der einem jeden Oberflächenbereich zugeordneten Position(en) und/oder Ausrichtung(en), wird der Messsensor relativ zu dem Objekt bewegt. Insbesondere kann er von Oberflächenbereich zu Oberflächenbereich bewegt werden, wenn mehrere aufeinanderfolgende Oberflächenbereiche vermessen werden sollen. Anders ausgedrückt kann der Messsensor von Position zu Position oder von Ausrichtung zu Ausrichtung bewegt werden, wobei die Positionen bzw. Ausrichtungen den aufeinanderfolgenden Oberflächenbereichen zugeordnet sind.

Jede dieser nicht-messenden Verfahrbewegungen erfordert Zeit, in der keine Objektvermessung stattfindet und die daher als nicht wertschöpfend bezeichnet werden kann. Folglich sollten derartige Bewegungen bzw. die hierfür erforderliche Zeit möglichst gering ausfallen.

Es sind daher Ansätze bekannt, mit denen an einem Objekt zu vermessende Oberflächenbereiche im Sinne einer Messreihenfolge (oder, mit anderen Worten, Abarbeitungsreihenfolge) derart sortiert werden, dass das erforderliche Bewegungsausmaß zwischen den Oberflächenbereichen möglichst gering ausfällt.

Die US 5 465 221 A lehrt in diesem Zusammenhang das Erstellen eines sogenannten Inspektionsplans, bei dem Inspektionspunkte in einer effizienten Reihenfolge sortiert werden. Hierfür wird auch auf Möglichkeiten zur Verwendung von "travelling salesman"-Algorithmen verwiesen.

In an sich bekannter Weise dienen "travelling salesman"-Algorithmen dazu, das sogenannte "travelling salesman problem" (TSP) oder auch "Problem des Handlungsreisenden" zu lösen. Bildlich gesprochen sollen diese Algorithmen eine optimale, da zum Beispiel kürzeste und/oder schnellste Route zum Abfahren mehrerer Bereiche oder Punkte ermitteln, wie es ein Handlungsreisender beim Abfahren mehrerer Orte tun müsste. Derartige Algorithmen werden hierin auch als TSP-Algorithmen bezeichnet.

Es existieren mehrere verschiedene Arten von Algorithmen, die auf die Lösung dieses Problems oder allgemein gesprochen eines Sortierproblems gerichtet sind. Es handelt sich hierbei allgemein um Optimierungsalgorithmen, welche die Reihenfolge derart festlegen, dass eine gewünschte Bewertungsgröße (zum Beispiel eine sogenannte Kostengröße) optimiert wird (z.B. maximiert oder minimiert wird, im Falle der Kostengröße bevorzugt minimiert).

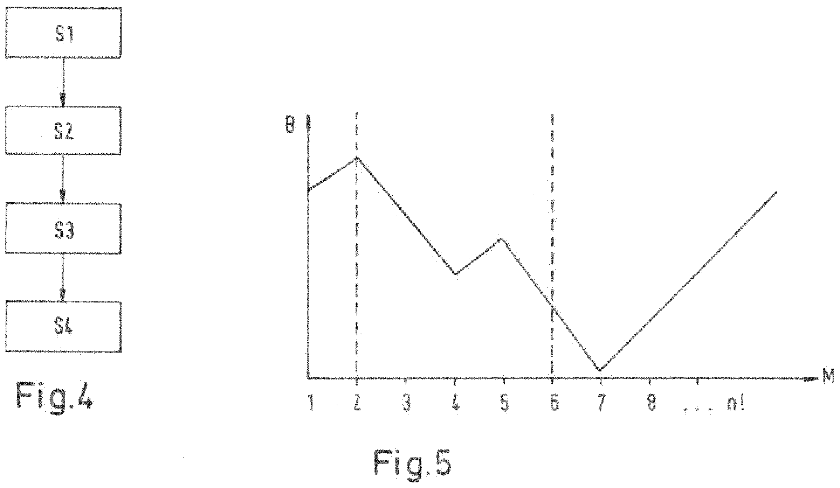

Hierfür werden verschiedene Sortierungen (oder, mit anderen Worten, Routen oder (Mess-) Reihenfolgen) von dem Algorithmus erstellt und ein Wert einer Bewertungsgröße für jede der Sortierungen ermittelt. Über eine Mehrzahl von Sortierungen bzw. Routen betrachtet unterliegt die Bewertungsgröße Veränderungen und weist lokale sowie absolute Extrema oder Optima auf. Dies verdeutlicht sich wenn man deren Werte entlang einer ersten Koordinatenachse und die dazugehörigen Sortierungen bzw. Routen entlang einer zweiten Koordinatenachse aufträgt. Durch Bilden eines solchen Graphens (aber auch unabhängig hiervon durch zum Beispiel Ablesen aus einer Wertetabelle) verdeutlicht sich, dass die Bewertungsgröße lokale Optima aufweisen kann aber auch ein absolutes Optimum. Ein Beispiel eines solchen Graphen findet sich in der nachfolgend erläuterten Figur 5 dieser Offenbarung. Die dazugehörigen optimalen Sortierungen können dann ausgewählt werden, um nach deren Maßgabe eine tatsächliche Werkstückvermessung durchzuführen (d. h. darauf basierend das Koordinatenmessgerät anzusteuern).

Bisher verwendete TSP-Algorithmen zeichnen sich jedoch durch einige Nachteile aus. Beispielsweise können diese eine sehr hohe Rechenzeit benötigen, bis sie ein absolutes Optimum gefunden haben. Auch können Sie dann, wenn sie ein lokales Optimum gefunden haben, nicht immer noch ein weiteres ggf. absolutes Optimum auffinden und/oder feststellen, ob es sich bei dem Optimum tatsächlich nur um ein lokales oder um das absolute Optimum handelt. Bildlich gesprochen können sich bekannte TSP-Algorithmen nicht immer aus lokalen Optima befreien, um noch weitere Sortierungen samt dazugehöriger Bewertungsgrößen zu ermitteln. Auch dies verdeutlicht sich aus der nachfolgend erläuterten Figur 5 dieser Offenbarung.

Aus Sicht eines Bedieners kann es daher zu unerwünschten Verzögerungen in der Planungsphase von Objektvermessungen mit einem Koordinatenmessgerät kommen, zum Beispiel während des Erstellens sogenannter Prüfpläne. Auch kann Unsicherheit darüber herrschen, ob eine ermittelte Messreihenfolge tatsächlich sinnvoll oder optimal ist bzw. eine höchstmögliche Effizienz gewährleistet.

Weiter ist es mit bisherigen TSP-Algorithmen auch nicht immer möglich, während des Messvorgangs einzuhaltende Bedingungen (z.B. Randbedingungen) ausreichend zu berücksichtigen. Selbst wenn also eine Messreihenfolge mit bevorzugten Werten der Bewertungsgröße ermittelt wurde, kann es sich herausstellen, dass diese für die praktische Objektvermessung ungeeignet ist. Dies kann wiederum zu Verzögerungen aufgrund erforderlicher Neuplanungen führen oder aber sogar zu Beschädigungen des Objekts oder Koordinatenmessgeräts bei einer Umsetzung dieser Messreihenfolge.

RAAD SALMAN ET AL, "An Industrially Validated CMM Inspection Process with Sequence Constraints", PROCEDIA CIRP, NL, 01.01.2016, Vol. 44, No. 44, doi:10.1016/j.procir.2016.02.136, ISSN 2212-8271, Seiten 138 - 143, beschreibt ein Überprüfungsverfahren mit einem Koordinatenmessgerät.

HAN ZHENHUA ET AL, "A 3D measuring path planning strategy for intelligent CMMs based on an improved ant colony algorithm", THE INTERNATIONAL JOURNAL OF ADVANCED MANUFACTURING TECHNOLOGY, SPRINGER, LONDON, Vol. 93, No. 1, doi:10.1007/S00170-017-0503-Y, ISSN 0268-3768, 16.06.2017, Seiten 1487 - 1497, beschreibt ein Verfahren zur Pfadplanung für ein Koordinatenmessgerät.

HAN Z ET AL, "Path planning method for intelligent CMMs based on safety and the highefficiency principle", INTERNATIONAL JOURNAL OF ADVANCED MANUFACTURING TECHNOLOGY, 01.04.2018, SPRINGER LONDON GBR, Vol. 95, No. 9-12, doi:10.1007/S00170-017-1500-X, Seiten 4003 - 4012, beschreibt ein Verfahren zur Pfadplanung für ein Koordinatenmessgerät.

QU L ET AL, "Optimization of the measuring path on a coordinate measuring machine using genetic algorithms", MEASUREMENT, INSTITUTE OF MEASUREMENT AND CONTROL. LONDON, GB, 01.04.1998, Vol. 23, No. 3, doi:10.1016/S0263-2241(98)00023-2, ISSN 0263-2241, Seeiten 159 - 170, beschreibt ein Verfahren zur Optimierung der Pfadplanung für ein Koordinatenmessgerät.

ZHAO F ET AL, "Computer-Aided Inspection Planning-The state of the art", COMPUTERS IN INDUSTRY, ELSEVIER, AMSTERDAM, NL, Vol. 60, No. 7, doi:10.1016/J.COMPIND.2009.02.002, ISSN 0166-3615, 01.09.2009, Seiten 453 - 466, beschreibt Verfahren zur computerbasierten Prüfplanung.

LI Y ET AL, "Free-form surface inspection techniques state of the art review", COMPUTER AIDED DESIGN, ELSEVIER PUBLISHERS BV., BARKING, GB, 01.11.2004, Vol. 36, No. 13, doi:10.1016/J.CAD.2004.02.009, ISSN 0010-4485, Seiten 1395 - 1417, beschreibt Prüfverfahren.

Die Erfindung richtet sich folglich auf die Aufgabe, das Ermitteln von für den praktischen Einsatz geeigneter Messreihenfolgen zum Vermessen eines Objektes mit einem Koordinatenmessgerät zu verbessern.

Diese Aufgabe wird mit dem Verfahren und einer Computereinrichtung gemäß den beigefügten unabhängigen Ansprüchen gelöst. Vorteilhafte Weiterbildungen sind in den abhängigen Ansprüchen angegeben.

Es versteht sich, dass sämtliche der vorstehenden Bemerkungen, Merkmale, Schritte und Wechselwirkungen auch bei der vorliegenden Lösung vorgesehen sein können, sofern nicht anders angegeben oder ersichtlich.

Es wird allgemein vorgeschlagen, aber nicht beansprucht, zum Vermeiden vorstehender Probleme mehrere Algorithmen einzusetzen, die für sich genommen jeweils eine Messereihenfolge variieren bzw. ändern. Insbesondere kann mit jedem der Algorithmen eine vorzugsweise mehrfache Änderung der Messreihenfolge erfolgen und können für jede geänderte Messreihenfolge mittels der Algorithmen Bewertungsgrößen ermittelt werden.

Dies bietet verschiedene Vorteile gegenüber dem bisherigen Einsatz lediglich eines TSP-Algorithmus. Zum einen kann die Anzahl unterschiedlicher Messreihenfolgen erhöht werden, für die Bewertungsgrößen ermittelt werden, sodass aus einer größeren Anzahl von Messreihenfolgen eine als geeignet ausgewählt werden kann. Auch kann dies schneller erfolgen, d.h. innerhalb einer vorgebebenen Zeitspannen kann eine entsprechend größere Anzahl an Messreihenfolgen betrachtet werden, als wenn nur ein Algorithmus verwendet werden würde. Weiter wird die Wahrscheinlichkeit erhöht, dass zumindest einer der Algorithmen sich bei Erreichen eines lokalen Optimums der Bewertungsgröße (insbesondere eines lokales Minimums) dennoch daraus befreien kann und/oder dass keiner der Algorithmen in einem lokalen Optima gefangen wird.

Ebenso können die Algorithmen derart kombiniert werden, dass sie eine Schwäche des jeweils anderen Algorithmus zumindest teilweise ausgleichen. Beispielsweise können ein schneller und ein langsamer Algorithmus kombiniert werden, wobei sich die Geschwindigkeit allgemein auf eine nachstehend erläuterte Rechengeschwindigkeit beziehen kann. Der Bediener kann dann selbst entscheiden, ob er ein mit dem schnellen Algorithmus ermitteltes Optimum der Bewertungsgröße, bei dem es sich aber lediglich um ein lokales Optimum handeln kann, annimmt, oder abwarten, ob der langsamere Algorithmus noch ein weiteres und gegebenenfalls absolutes Optimum auffindet. Es können auch Algorithmen mit unterschiedlicher Güte oder unterschiedlicher Ausgabefrequenz von Zwischenergebnissen kombiniert werden. Weiter können die Algorithmen gemäß einer Ausführungsform von unterschiedlichen initialen Messreihenfolgen ausgehen, was nachstehend erläuterte Vorteile mit sich bringt.

Im Detail wird ein Verfahren zum Auswählen einer Messreihenfolge für ein Koordinatenmessgerät vorgeschlagen aber nicht beansprucht, mit:
a) Erhalten einer Mehrzahl von Oberflächenbereichen eines Objekts, die (jeweils) hinsichtlich wenigstens einer vorbestimmten Eigenschaft mit einem Messsensor vermessen werden sollen, wobei der Messsensor von dem Koordinatenmessgerät zum Vermessen eines jeweiligen Oberflächenbereichs in wenigstens einer spezifischen (z.B. oberflächenbereichsspezifischen) Position und/oder mit wenigstens einer spezifischen (z.B. oberflächenbereichsspezifischen) Ausrichtung anzuordnen ist;
b) mehrmaliges Ändern einer Messreihenfolge, in der die Oberflächenbereiche vermessen werden sollen, mit einem ersten Algorithmus und mit einem zweiten Algorithmus, wobei die Algorithmen im Rahmen einer jeden Änderung jeweils eine geänderte Messreihenfolge samt einer Bewertungsgröße (bzw. einen Wert für diese Bewertungsgröße) für diese (geänderte) Messreihenfolge ermitteln;
c) Auswählen einer der Messreihenfolgen anhand der (insgesamt) ermittelten (Werte der) Bewertungsgröße(n).

Das Verfahren kann ferner optional den Schritt des Ausführens der ausgewählten Messreihenfolge mit einem Koordinatenmessgerät umfassen und/oder des Ansteuerns des Koordinatenmessgeräts zum Ausführen der ausgewählten Messreihenfolge.

Das Verfahren richtet sich auch auf eine Computereinrichtung, die dazu eingerichtet ist, ein Verfahren der vorstehenden Art auszuführen, aber auch jeglicher der nachstehenden Varianten, Weiterbildungen und Ausführungsformen. Die Computereinrichtung kann wenigstens einen Mikroprozessor umfassen. Allgemein kann die Computereinrichtung dazu eingerichtet sein, Programmanweisungen und insbesondere die vorstehenden Algorithmen zu verarbeiten und/oder auszuführen, und darauf basierend die einzelnen Verfahrensschritte durchzuführen.

Insbesondere kann die Computereinrichtung eine (zum Beispiel digitale und/oder elektronische) Speichereinrichtung umfassen oder mit einer solchen verbunden sein und von dieser die Oberflächenbereiche des Objekts erhalten. Die Computereinrichtung kann aber auch dazu eingerichtet sein, zum Beispiel anhand eines CAD Modells und/oder auf Basis von Benutzereingaben die entsprechenden Oberflächenbereiche sowie zu vermessenden Eigenschaften zu ermitteln. Weiter kann die Computereinrichtung zum Auswählen der Messreihenfolge die Bewertungsgrößen vergleichen bzw. eine hinsichtlich eines vorbestimmten Auswahlkriteriums beste Bewertungsgröße auswählen.

Bei den Oberflächenbereichen kann es sich um Bereiche mit vorbestimmten geometrischen Eigenschaften und insbesondere um Messelemente der vorstehend erläuterten Art handeln. Ein Oberflächenbereich kann auch lediglich punktförmig sein bzw. einen Messpunkt definieren. Somit kann die Messreihenfolge auch eine Punktabfolge definieren, gemäß derer eine Mehrzahl von Messpunkten mit dem Messsensor zu erfassen ist (zum Beispiel hinsichtlich deren Koordinaten vermessen werden soll). Es sind auch Mischformen denkbar, bei denen zweidimensionale Oberflächenbereiche und eindimensionale Oberflächenbereiche (d. h. einzelne Messpunkte) eine Messreihenfolge im Sinne der Erfindung bilden.

Bei den vorbestimmten Eigenschaften kann es sich um die hierin diskutierten Prüfmerkmale handeln. Der Messsensor kann ein taktiler Sensor sein und zum Beispiel einen Taststift umfassen. Alternativ kann der Messsensor ein optischer Sensor sein und zum Beispiel eine Kamera umfassen, mit der zur Vermessung eines Oberflächenbereiches ein oder mehrere Kamerabild(er) des Oberflächenbereichs erfasst werden.

Das Koordinatenmessgerät kann gemäß jeglicher herkömmlichen Bauart ausgebildet sein und beispielsweise eine Mehrzahl von orthogonal zueinander angeordneten Maschinenachsen (insbesondere linearen Achsen) umfassen. Gemäß einer Variante handelt es sich um ein Koordinatenmessgerät in Portalbauweise. Allgemein kann das Koordinatenmessgerät dazu eingerichtet sein, den Sensor innerhalb eines Arbeitsraums, in dem auch das zu vermessende Objekt angeordnet ist, relativ zu diesem Objekt anzuordnen und/oder auszurichten. Hierfür kann es auch einen Objektdrehtisch umfassen. Weiter kann das Koordinatenmessgerät dazu eingerichtet sein, unter Auslesen der eigenen Maschinenachsenpositionen und/oder auf Basis der ermittelten Messsensorsignale Koordinatenwerte des Objekts zu ermitteln, beispielsweise von einem aktuell angetasteten Punkt auf der Objektoberfläche. Ein Beispiel eines auch vorliegend verwendbaren Koordinatenmessgeräts findet sich in der EP 0 790 478 B1 der Anmelderin und wird dort unter Bezugnahme auf Figur 1 erläutert.

Das Koordinatenmessgerät kann den Messsensor zum Einnehmen der Positionen und/oder Ausrichtungen je Oberflächenbereich relativ zu dem Objekt bewegen. Dies gilt insbesondere dann, wenn von einem bereits vermessenen Oberflächenbereich zu einem nachfolgenden Oberflächenbereich gewechselt werden soll. Dann kann das Koordinatenmessgerät den Sensor ausgehend von einer Position zum Vermessen des vorangehenden Oberflächenbereichs zu einer Position des nachfolgenden Oberflächenbereichs bewegen oder aber eine Ausrichtung entsprechend ändern (von einer Ausrichtung zum Vermessen des vorangehenden zu einer Ausrichtung zum Vermessen des nachfolgenden Oberflächenbereichs).

Derartige Bewegungen zwischen den Oberflächenbereichen können in Abhängigkeit von der Messreihenfolge festgelegt bzw. nach Maßgabe hiervon definiert sein. Diese Bewegungen können jedoch nicht wertschöpfende oder allgemein unerwünschte und folglich möglichst kurz zu haltende Bewegungen darstellen. Mittels der Algorithmen sollten diese bevorzugt möglichst hin zu entsprechend schnell ausführbaren Bewegungen optimiert werden.

Das mehrmalige Ändern der Messreihenfolge oder, anders ausgedrückt, mehrmalige Variieren kann virtuell oder, mit anderen Worten, rechnerisch stattfinden. Beispielsweise können im Rahmen einer Ausführung der Algorithmen mehrere verschiedene virtuelle Messreihenfolgen definiert werden, wobei dann für diese virtuellen Messreihenfolgen ein jeweiliger Wert der Bewertungsgröße berechnet und/oder per Simulation bestimmt wird. Beispiele hierzu werden nachfolgend anhand der Figuren erläutert. Anhand der Bewertungsgröße kann ein Algorithmus dann auch über die Art und/oder das Ausmaß einer Änderung der Messreihenfolgen entscheiden.

Es ist aber auch möglich, die Bewertungsgröße anhand vorab hinterlegter Werte auszulesen und dadurch zu ermitteln. Beispielsweise kann die Bewertungsgröße für einzelne Messreihenfolgen und/oder zumindest für einzelne Bewegungen zwischen ausgewählten Oberflächenbereichen vorberechnet worden sein. Je nach aktueller Messreihenfolge können diese vorberechneten Informationen ausgelesen und zur Bewertungsgröße der (Gesamt-) Messreihenfolge zusammengesetzt werden. Auch ein solches Vorgehen stellt ein Ermitteln der Bewertungsgröße im Sinne der vorliegenden Erfindung dar.

Insbesondere können für jede Messreihenfolge die Messsensorbewegungen und/oder Maschinenachsenbewegungen ermittelt werden, die zumindest dafür erforderlich sind, um den Messsensor zwischen den Oberflächenbereichen zu bewegen (d. h. zwischen den laut der Messreihenfolge aufeinanderfolgenden Oberflächenbereichen zu bewegen).

Zusätzlich oder alternativ können aber auch Bewegungen zum Anfahren mehrerer Positionen und/oder zum Einnehmen mehrerer Ausrichtungen innerhalb eines Oberflächenbereichs betrachtet werden (d. h. die zum Vermessen der diesem Oberflächenbereich zugeordneten Eigenschaften erforderlich sind). Anders ausgedrückt können die Bewegungen zum Bestimmen der Prüfmerkmale zusätzlich oder alternativ den Wert der Bewertungsgröße zumindest mitbestimmen.

Allgemein können zum Ermitteln von Werten der Bewertungsgröße auf Basis erforderlicher Bewegungen die Messsensorbewegungen und/oder Maschinenachsenbewegungen per Simulation oder mittels NC-Algorithmen ermittelt werden. Im Falle einer Vorberechnung können diese Bewegungen auch ausgelesen werden zum Beispiel je nach laut einer aktuellen Messreihenfolge aufeinanderfolgenden Oberflächenbereichen zu einem Gesamtbewegungsablauf zusammengesetzt werden.

Insbesondere können eine zuletzt eingenommene Messsensorposition und/oder Messsensorausrichtung in einem vorangehend vermessenen Oberflächenbereich (d. h. eine Endposition oder Endausrichtung) und eine in einem nachfolgenden Oberflächenbereich zuerst einzunehmende Messsensorposition und/oder Messsensorausrichtung betrachtet werden (d. h. eine Startposition oder Startausrichtung). Die zur Festlegung der Bewertungsgröße betrachteten Bewegungen können dann die Bewegungen zwischen den entsprechend Start- bzw. Endpositionen und/oder - ausrichtungen sein.

Handelt es sich bei dem Messsensor um einen optischen Sensor und insbesondere eine Kamera, kann berücksichtigt werden, wie viele Ausrichtungen und/oder Positionen einzunehmen sind, um die gewünschten Eigenschaften ermitteln zu können. Erneut können die hierfür erforderlichen (Verfahr-) Bewegungen des Messsensors und insbesondere deren Ausmaß bzw. Distanz betrachtet werden. Prinzipiell könnte aber auch lediglich die Anzahl an einzelnen Bewegungen berücksichtigt werden. In diesem Fall ist es vorteilhaft, wenn mit nur einer Kameraausrichtung und/oder in nur einer Kameraposition Informationen (insbesondere Bilder) erfassbar sind, mit denen mehrere Eigenschaften desselben oder von unterschiedlichen Oberflächenbereichen gleichzeitig ermittelt werden können. In diesem Fall können die mit einem zu vermessenden Oberflächenbereich zusammenhängenden Kosten bzw. Bewegungen sogar zu Null gesetzt werden, wenn dieser Oberflächenbereich bereits beim Vermessen eines anderen Oberflächenbereichs sozusagen parallel mit erfassbar ist.

In an sich bekannter Weise, können in den Wert der Bewertungsgröße auch Tasterwechselvorgänge einfließen. In diesem Fall kann ein festgesetzter Wert zugrunde gelegt werden (zum Beispiel als Zeitverlust bzw. Zeitbedarf für den Tasterwechsel, der nicht bei jedem Tasterwechselvorgang erneut bestimmt werden muss). Es können aber auch konkrete Umstände des Tasterwechselsvorgang berücksichtigt werden, beispielsweise von welchem Oberflächenbereich aus ein Tastermagazin anzufahren ist und/oder welcher Oberflächenbereich nach dem Tastermagazin anzufahren ist.

Basierend auf einer festgelegten Messreihenfolge kann in an sich bekannter Weise automatisch erkannt werden, dass ein Tasterwechsel erforderlich ist, beispielsweise wenn gemäß der Messreihenfolge aufeinanderfolgend zu vermessende Oberflächenbereich samt hierfür zu bestimmender Eigenschaften unterschiedliche Taster erfordern und/oder der Zusammenhang zwischen zu bestimmenden Eigenschaften und hierfür erforderlichen Tastern in einer Datenbank hinterlegt ist. Alternativ kann dieser Zusammenhang auch direkt in einem Prüfplan gespeichert sein.

Bei den Algorithmen handelt es sich vorzugsweise um Sortieralgorithmen, welche die Reihenfolge, in der die Oberflächenbereiche vermessen werden sollen, mittels einer entsprechenden Sortierung festlegen. Ein Beispiel für derartige Sortieralgorithmen sind TSP-Algorithmen der einleitend geschilderten Art, die erfindungsgemäß ebenso zum Einsatz kommen können. Der erste und der zweite Algorithmus können gleichartig sein. Es kann sich aber auch um verschiedenartige Algorithmen handeln. Konkrete Beispiele und Vorteile für Kombinationen unterschiedlicher oder gleichartiger Algorithmen werden nachstehend genannt.

Bei der Bewertungsgröße kann es sich um eine Kostengröße handeln, wie sie im Kontext von allgemeinen Optimierungsalgorithmen üblicherweise verwendet werden. Die Bewertungsgröße und insbesondere Kostengröße kann demnach eine Größe und/oder Eigenschaft angeben, die mittels der Algorithmen und durch Festlegen einer geeigneten Messreihenfolge minimiert werden soll. Es kann sich aber ebenso um eine zu maximierende Größe handeln. Ein Beispiel der Bewertungsgröße ist eine für die Vermessung des Objekts insgesamt benötigte Messzeitdauer. Ebenso kann das Ausmaß (zum Beispiel die Distanz) der erforderlichen Maschinenachsenbewegungen betrachtet werden, insbesondere im Hinblick auf die Bewegungen zwischen den einzelnen Oberflächenbereichen.

Bewegungen zum Bestimmen der Eigenschaften innerhalb eines bzw. mit Bezug auf nur einen Oberflächenbereich können beim Ermitteln der Bewertungsgröße hingegen unberücksichtigt bleiben und/oder allgemein keinen Einfluss auf die Bewertungsgröße haben. Dem liegt der Gedanke zugrunde, dass derartige Bewegungen bereits vordefiniert sein können und gegebenenfalls bereits optimiert wurden. Je nach zu vermessender Eigenschaft bzw. je nach zu vermessenden Prüfmerkmal können diese dann in vorbestimmte Weise ausgeführt werden, ohne dass es einer weiteren Optimierung durch die hierin vorgestellten Algorithmen bedarf.

Beispielsweise kann ein Durchmesser in stets derselben Weise ermittelt werden, sodass die Bewegung hierfür nicht mehr neu bestimmt und bewertet werden müssen. Sollen für einen Oberflächenbereich mehrere Prüfmerkmale bestimmt werden, können aber zumindest Bewegungen zwischen Positionen und/Ausrichtung zum Bestimmen dieser Prüfmerkmale zum Ermitteln der Bewertungsgröße mit berücksichtigt werden. In diesem Fall kann auch jedes Prüfmerkmal bzw. jeder Messpunkt oder eine Gruppe von Messpunkten zum Bestimmen eines Prüfmerkmals einen Oberflächenbereich im Sinne der Erfindung bilden und kann eine Reihenfolge der Prüfmerkmale im Sinne einer Messreihenfolge geändert und bewertet werden. Als zu bestimmende Eigenschaft können dann die Koordinaten der Messpunkte ermittelt werden, aus denen dann das Prüfmerkmal ermittelt wird.

Zusammengefasst können sich die Algorithmen und deren Bewertungsgröße somit vorzugsweise ausschließlich auf die Bewegungen zwischen den Oberflächenbereichen beziehen und/oder kann die Messreihenfolge derartige Bewegungen zumindest mittelbar definieren. Dabei kann auch zusätzlich berücksichtigt werden, dass um die Oberflächenbereiche optional virtuelle Räume definiert werden können, in denen zwecks Kollisionsvermeidung keine beliebigen Messsensorbewegungen möglich sind. Stattdessen kann innerhalb dieser Räume zum Beispiel nur eine senkrecht zur Objektoberfläche stattfinde Bewegung zulässig sein. Die zur Ermittlung der Bewertungsgröße herangezogenen Bewegungen können sich somit auch auf lediglich diejenigen Bewegungen beziehen, die zwischen den Oberflächenbereichen und außerhalb derartiger virtueller Räume stattfinden.

Sofern hierin von einem Optimum gesprochen wird, kann dies sowohl ein lokales als auch ein absolutes Optimum einschließen. Ein Optimum kann sowohl ein Minimum als auch ein Maximum sein. Weiter kann sich der Begriff Optimum allgemein auf einen optimalen Wert der Bewertungsgröße beziehen. Eine optimale Messreihenfolge kann folglich eine Messreihenfolge sein, bei der die Bewertungsgröße einen optimalen Wert annimmt.

Das Auswählen der Messreihenfolge anhand der ermittelten Bewertungsgrößen kann umfassen, dass eine Messreihenfolge mit einer Bewertungsgröße ausgewählt wird, welche ein vorbestimmtes Auswahlkriterium erfüllt. Das Auswahlkriterium kann zum Beispiel definieren, dass die beste, optimale (zum Beispiel minimale oder maximale) oder allgemein eine bevorzugte Bewertungsgröße samt dazugehöriger Messreihenfolge ausgewählt wird. Beispielsweise kann die Messreihenfolge mit der geringsten Messzeitdauer oder mit den geringsten Maschinenbewegungen (zum Beispiel gemessen als Bewegungsdistanz) ausgewählt werden.

Eine Weiterbildung der Erfindung sieht vor, dass der Messsensor (zum Beispiel vom Koordinatenmessgerät) zum Vermessen aufeinanderfolgender Oberflächenbereiche relativ zu dem Objekt bewegt wird, um die den Oberflächenbereichen jeweils zugeordnete wenigstens eine Position und/oder Ausrichtung einzunehmen. Wie geschildert, können diese Bewegungen und insbesondere ausschließlich diese Bewegungen zur Ermittlung eines Werts der Bewertungsgröße herangezogen werden. Hingegen können Bewegungen zum Bestimmen der Eigenschaften des Oberflächenbereichs, die zum Beispiel innerhalb dieses Oberflächenbereich stattfinden und/oder zum Wechseln Positionen und/oder Ausrichtungen innerhalb eines einzigen Oberflächenbereichs vorgesehen sind, bei dem Ermitteln der Bewertungsgröße unberücksichtigt bleiben.

Zusammengefasst kann die Bewertungsgröße also anhand der Bewegungen des Messsensors ermittelt werden, die zum Erreichen (und/oder Anfahren) von (z.B. laut einer aktuell betrachteten bzw. geänderten Messreihenfolge) aufeinanderfolgenden Oberflächenbereichen erforderlich sind. Das Erreichen kann insbesondere umfassen, dass die wenigstens eine Position und/oder wenigstens einer Ausrichtung (und insbesondere eine hierin erläuterte Startposition oder Startausrichtung) des Oberflächenbereichs von dem Messsensor erreicht bzw. eingenommen wird.

Eine Ermittlung anhand der Bewegungen kann umfassen, dass die Bewertungsgröße ausgehend von und/oder zumindest mittelbar auf Basis dieser Bewegungen bestimmt wird. Die Bewegungsgröße kann z.B. den Energieverbrauch oder eine (bspw. kumulierte) Pfadlänge ausgeführter Bewegungen (z.B. Messsensorbewegungen) angeben, welche vorzugsweise beide anhand der ermittelten erforderlichen Bewegungen bestimmt werden.

Wie erwähnt, können die Algorithmen jeweils auf Lösungsansätzen zum (Lösen des) Problem(s) des Handlungsreisenden beruhen. Hierunter kann verstanden werden, dass eine optimale Route zwischen anzufahrenden Orten und in dem vorliegenden Fall von mit dem Messsensor anzufahrenden Oberflächenbereichen ermittelt werden soll, welche die Bewertungsgröße in einer gewünschten Weise optimiert (zum Beispiel maximiert oder minimiert).

Derartige Algorithmen sind bekannt, unterscheiden sich jedoch hinsichtlich Eigenschaften wie einer Rechengeschwindigkeit, einer Güte, einer Ausgabefrequenz von Zwischenergebnissen sowie allgemein der Fähigkeit, sich aus lokalen Optima und insbesondere lokalen Minima der Bewertungsgröße wieder zu befreien. Beispiele für derartige Algorithmen sind sogenannte Tabu-Search-Algorithmen, Nearest-Neighbor-Algorithmen, k-Opt-Algorithmen (z.B. ein 3-Opt-Algorithmus), Christofides-Heuristik-Algorithmen oder Guided-Local-Search-Algorithmen.

Unter der Rechengeschwindigkeit kann diejenige Geschwindigkeit verstanden werden, die der Algorithmus benötigt, um zu einem aus seiner Sicht optimalen Ergebnis zu gelangen (beispielsweise um ein zumindest lokales Optima aufzufinden).

Unter der Güte kann die Auflösungsfähigkeit und/oder allgemein die Genauigkeit eines Algorithmus Optima verstanden werden, beispielsweise inwieweit ein aufgefundenes Optimum von einem tatsächlichen (d. h. objektiven) Optimum und insbesondere einem absoluten Optimum abweicht. Aufgrund der von den Algorithmen durchgeführten Änderungen und insbesondere eines Änderungsausmaßes ist nicht immer gewährleistet, dass ein entsprechendes objektives Optimum tatsächlich aufgefunden wird bzw. dass ein aus Sicht des Algorithmus optimales Ergebnis tatsächlich auch unter objektiven Gesichtspunkten optimal ist. Weiter kann die Güte andere Eigenschaften des Algorithmus betreffen oder von diesen zumindest mitbestimmt werden. Derartige Eigenschaften können beispielsweise die Fähigkeit sein, von einer vorgegebenen Initialroute auszugehen, der Speicherverbrauch oder eine Ausgabefrequenz von Fortschrittsinformationen.

Wenn hierin Algorithmen zum Beispiel hinsichtlich der vorstehend genannten Eigenschaften miteinander verglichen werden, versteht es sich, dass sich diese Vergleiche auf im Durchschnitt erzielbare Eigenschaften und Verhältnisse beziehen, beispielsweise wenn die Algorithmen für eine Mehrzahl unterschiedlicher Optimierungsaufgaben eingesetzt werden. Anders ausgedrückt kann es sich um aus Sicht des Fachmanns objektiv zutreffende Eigenschaften handeln, die jedoch je nach Ausgangslage und konkreter Optimierungsaufgabe nicht immer unmittelbar zutreffen können, jedoch über eine Mehrzahl von Optimierungsaufgaben betrachtet entsprechend eintreffen. So kann zum Beispiel ein hierin als langsamerer Algorithmus bezeichneter Algorithmus für einen Einzelfall und zum Beispiel aufgrund einer zufällig gewählten besonders geeigneten Initialroute schneller zu einem optimalen Ergebnis gelangen, als ein hierin als schnell bezeichneter Algorithmus, der jedoch von einer vergleichsweise ungünstigen Initialroute aus startet. Dies trifft jedoch nicht zu, wenn diese Algorithmen auf eine Mehrzahl unterschiedlicher Initialrouten angewandt werden und z.B. auf mindestens zehn unterschiedliche Initialrouten.

Gemäß einer Ausführungsform der hierin vorgestellten Verfahren und Computereinrichtungen ermittelt der erste Algorithmus eine initiale Messreihenfolge als Ausgangsreihenfolge für den zweiten Algorithmus. In diesem Fall unterscheiden sich der erste und der zweite Algorithmus bevorzugt voneinander. Insbesondere kann der erste Algorithmus dazu eingerichtet sein, ein aus seiner Sicht optimales Ergebnis schneller als der zweite Algorithmus zu ermitteln. Hingegen kann der zweite Algorithmus genauer sein (d. h. mit einer höheren Wahrscheinlichkeit ein objektiv zutreffendes Optimum ermitteln) und/oder kann sich mit einer höheren Wahrscheinlichkeit aus lokalen Optima und insbesondere Minima befreien, um möglicherweise ein noch besseres Optimum und insbesondere das absolute Optimum aufzufinden.

Bei der initialen Messreihenfolge kann es sich um eine sogenannte Initialroute handeln. Diese (aber auch die allgemeine initiale Messreihenfolge) kann von dem zweiten Algorithmus verwendet werden, um darauf aufbauend sukzessive Änderungen vorzunehmen. Beispielsweise können je nach den im Algorithmus hinterlegten Regeln Änderungen dieser Initialroute stattfinden und zwar in einer Weise bzw. in eine Richtung, in der ein vermutetes (zum Beispiel absolutes) Optimum liegt.

Insbesondere kann mit dem ersten Algorithmus eine Messreihenfolge mit einem zumindest lokalen Optimum der Bewertungsgröße schneller auffindbar sein als mit dem zweiten Algorithmus. Dies kann zum Beispiel darin begründet sein, dass der erste Algorithmus größere Änderungen vornimmt (d. h. allgemein weniger feinauflösend ist) und somit schneller in die Nähe eines möglicherweise optimalen Ergebnisses gelangt. Insbesondere kann der erste Algorithmus ein Nearest-Neighbor-Algorithmus oder k-Opt-Algorithmus sein (mit vorzugsweise niedrigem k bspw. von weniger als drei oder zumindest weniger als der zweite Algorithmus). Allgemein gilt für K-Opt-Algorithmen: Je höher K, desto größere Umwege (die z.B. die Routenlänge erhöhen) werden akzeptiert oder, mit anderen Worten, desto größer das in Kauf genommen Ausmaß etwaiger Verschlechterungen der Bewertungsgröße bei einer erneuten Messreihenfolge-Variation. Dadurch ist es möglich, dass lokalen Minima entkommen werden kann. Andererseits kann die Rechendauer steigen, da insgesamt mehr Permutationen abzuarbeiten sind. Generell kann also die Anzahl der Änderungen, die von einem Algorithmus vorgenommen werden, die Rechenzeit ebenfalls beeinflussen.

Zusätzlich oder alternativ kann die Wahrscheinlichkeit des Ermittelns einer Messreihenfolge mit einer weiteren zumindest lokal optimalen Bewertungsgröße, nachdem bereits eine Messreihenfolge mit einer zumindest lokal optimalen Bewertungsgröße aufgefunden wurde, mit dem zweiten Algorithmus größer sein als mit dem ersten Algorithmus, beispielsweise da sich der zweite Algorithmus mit einer höheren Wahrscheinlichkeit aus einem erreichten lokalen Optima noch einmal befreien kann bzw. dieses mit einer höheren Wascheinigkeit noch einmal verlassen kann. Dies kann zum Beispiel dadurch erreicht werden, dass der zweite Algorithmus eine Heuristik und/oder Metaheuristik umfasst, der erste Algorithmus bevorzugt hingegen nicht oder aber eine weniger genaue Heuristik (z.B. eine sog. 2-opt-Heuristik für den ersten und eine 5-opt-Heuristik für den zweiten Algorithmus). Eine Heuristik kann in an sicher bekannter Weise eine näherungsweise Lösung von Optimierungsproblemen (von z.B. der vorliegenden Bewertungsgröße) ermöglichen. Der näherungsweise Ansatz stellt eine Alternative zu Brute-Force oder vollständigen Lösungsansätzen dar, die sämtliche Permutationen betrachten. Hierfür kann die Heuristik Rechenregeln, Rechenschritte oder allgemeine Vorgehensweisen definieren, wie ein solches Optimierungsproblem näherungsweise zu lösen ist. Bei einer Metaheuristik kann es sich um eine Heuristik handeln, die innerhalb eines Algorithmus (bspw. selektiv) zum Entkommen aus lokalen Optima eingesetzt wird. Sämtliche der geschilderten Varianten, bei denen ein Algorithmus eine Initialroute für den anderen Algorithmus ermittelt, bieten den Vorteil, dass ein absolutes Optimum gegebenenfalls schneller erreicht wird. Beispielsweise kann der erste Algorithmus das absolute Optimum bereits auffinden, was von dem zweiten Algorithmus dann nur noch bestätigt wird, oder aber der zweite Algorithmus muss nur noch wenige Änderungen vornehmen, um zu diesem absoluten Optimum zu gelangen. Dies gilt insbesondere im Vergleich zu dem Fall, dass der zweite Algorithmus ohne entsprechende Vorbereitung von einer beliebigen Initialroute aus startet. Diese Vorteile werden nachstehend im Zusammenhang mit der Figurenbeschreibung noch näher erläutert.

Gemäß einer weiteren Ausführungsform der Verfahren und Computereinrichtungen werden der erste und der zweite Algorithmus zumindest teilweise parallel ausgeführt, d. h. überlappen zumindest teilweise zeitlich miteinander. Insbesondere können die Algorithmen zeitgleich oder mit nur wenigen Sekunden oder Minuten relativer Verzögerung gestartet werden (z.B. weniger als 30 Sekunden oder weniger als 3 Minuten).

In diesem Fall können gleichartige Algorithmen zum Einsatz kommen, die jedoch von unterschiedlichen initialen Messreihenfolge (oder auch Initialrouten) ausgehen. Anders ausgedrückt können der erste und der zweite Algorithmus gleichartig sein aber von unterschiedlichen initialen Messreihenfolgen ausgehen.

Beispielsweise kann eine allgemeine initiale Messreihenfolge vorgegeben, aber je nach Algorithmus unterschiedlich verrauscht oder, mit anderen Worten, z.B. mittels einer Zufallsvariable oder aber deterministisch unterschiedlich variiert werden, bevor sie von den Algorithmen verarbeitet wird (d. h. von diesen sukzessive geändert und optimiert wird).

Hierdurch wird die Wahrscheinlichkeit erhöht, dass zumindest einer der Algorithmen bereits in der Nähe zu einem Optimum startet und somit mit nur wenigen Änderungen zu einem optimalen Ergebnis gelangt. Auch kann hierdurch die Wahrscheinlichkeit erhöht werden, dass zumindest einer der Algorithmen nicht bereits frühzeitig ein Abbruchkriterium erfüllt und/oder einen Zustand erreicht, indem er kein weiteres Optimum mehr auffinden kann, beispielsweise da er sich aus einem lokalen Minimum nicht mehr befreien kann.

Die Algorithmen können aber auch verschiedenartig voneinander sein, wenn diese zunächst teilweise parallel ausgeführt werden. Dann ist es nicht zwingend erforderlich, unterschiedliche initiale Messreihenfolgen vorzusehen, was aber dennoch erfolgen kann.

Insbesondere können die Algorithmen sich hinsichtlich der Rechengeschwindigkeit und/oder einer Ausgabefrequenz von Zwischenergebnissen unterscheiden. Bei den Zwischenergebnissen kann es sich um eine aktuell als optimal bewertete Messreihenfolge handeln, die zum Beispiel immer dann aktualisiert werden kann, wenn eine noch bessere bzw. optimalere Messreihenfolge aufgefunden wurde. Es kann sich auch allgemein um eine Fortschrittsangabe handeln, beispielsweise inwieweit der Algorithmus von einem vermuteten globalen Optimum entfernt ist bzw. wie viele Änderungen oder Variationen der Messreihenfolge er bereits abgearbeitet hat.

Zusätzlich oder alternativ können sich die Algorithmen auch hinsichtlich der vorstehend erläuterten Güte oder hinsichtlich anderer Eigenschaften voneinander unterscheiden und/oder unterschiedliche Metaheuristiken aufweisen. Beispielsweise können Unterschiede erneut in der Form vorliegen, dass einer der Algorithmen schneller ist und/oder dass einer der Algorithmen sich mit einer höheren Wahrscheinlichkeit aus einem lokalen Optima befreien kann (bzw. nach einem bereits aufgefundenen Optimum ein noch weiteres Optimum auffinden kann).

Als vorteilhaft hat sich bspw. erwiesen, einen Guided-Local-Search-Algorithmus mit einem Tabu-Search-Algorithmus zu kombinieren oder, genauer gesagt, diese zumindest teilweise parallel auszuführen. Ersterer zeichnet sich durch eine höhere Rechengeschwindigkeit aus, wohingegen Letzterer öfter Zwischenergebnisse ausgibt. Dies ist dahingehend vorteilhaft, als dass bei einem vorzeitigen Abbruch durch z.B. den Bediener oftmals das bisher ermittelte beste Zwischenergebnis für eine weitere Verwendung ausgewählt wird. Bei einer höheren Ausgabefrequenz ist die Wahrscheinlichkeit höher, dass bereits ein Zwischenergebnis nahe des tatsächlichen Optimums vorliegt.

Weiter kann vorgesehen sein, dass für wenigstens einen der Algorithmen ein vorbestimmtes Abbruchkriterium definiert ist. Sobald dieses erfüllt es, kann der Algorithmus weitere Änderungen der Messreihenfolge unterbinden und zum Beispiel eine bisher als optimal ermittelte Bewertungsgröße samt dazugehöriger Messreihenfolge kann als bestes Ergebnis ausgewählt werden.

Insbesondere kann als Abbruchkriterium für wenigstens einen der Algorithmen eine maximal zulässige Anzahl an Änderungen der Messreihenfolge ohne Auffinden einer zumindest lokal optimalen Bewertungsgröße definiert sein. Dieses Abbruchkriterium kann insbesondere erst dann erfüllbar sein bzw. zum Tragen kommen, wenn bereits ein (zumindest lokales) Optimum aufgefunden wurde. Wird innerhalb einer vorbestimmten Anzahl an Änderungen der Messreihenfolge dann nicht erneut ein weiteres Optimum aufgefunden, kann darauf geschlossen werden, dass sich der Algorithmus bereits nahe des absoluten Optimums befindet und/oder sich nicht aus dem bisher ermittelten Optimum befreien kann.

Ein derartiges Abbruchkriterium gewährleistet, dass die Rechenzeit nicht unnötig erhöht wird bzw. ein Bediener ausreichend früh in Kenntnis darüber gesetzt wird, dass voraussichtlich keine weiteren Verbesserungen erzielbar sind.

In diesem Zusammenhang kann die maximal zulässige Anzahl an Variationen in Abhängigkeit von der Anzahl an (erhaltenen) Oberflächenbereichen gewählt sein. Insbesondere kann diese zulässige Anzahl proportional zu der Anzahl von Oberflächenbereichen gewählt sein und/oder allgemein kann gelten: je höher die Anzahl von Oberflächenbereichen, desto höher die zulässige Anzahl.

Dies trägt dem Umstand Rechnung, dass mit zunehmender Anzahl von Oberflächenbereichen auch zunehmende Möglichkeiten für Änderungen und/oder zum Festlegen geänderter Messreihenfolge bestehen. Somit kann bei einer entsprechend erhöhten zulässigen Anzahl die Aussagekraft dahingehend gesteigert werden, dass bei Abbruch des Algorithmus tatsächlich davon auszugehen ist, dass keine weitere Verbesserung in akzeptabler Zeit mehr erzielbar ist.

Als ein weiterer Aspekt der Offenbarung können zusätzlich oder alternativ zu Schritt b) die Messreihenfolgen derart definiert und/oder geändert werden, dass die Oberflächenbereiche von mehreren Koordinatenmessgeräten mit vorzugsweise jeweils einem Messsensor vermessen und/oder zwischen diesen Koordinatenmessgeräten aufgeteilt werden. Das Objekt kann also mit mehreren Koordinatenmessgeräten vermessen werden. Diese können jeweils eine Teilmenge der erhaltenen Oberflächenbereiche vermessen. Die Aufteilung, welches Koordinatenmessgerät welchen Oberflächenbereich vermisst, kann ebenfalls Bestandteil einer hierin geschilderten Messreihenfolge sein bzw. durch diese festgelegt werden. Somit kann auch wenigstens ein Algorithmus (gegebenenfalls aber auch zwei Algorithmen) vorgesehen sein, der die Messreihenfolge unter Änderung dieser Aufteilung ändert und für jede entsprechend geänderte Messreihenfolge auch eine Bewertungsgröße ermittelt. Die schlussendlich ausgewählte Messreihenfolge kann dann die optimalste (zum Beispiel die schnellste) Bewertungsgröße ergeben. Eine Änderung der Messreihenfolge kann aber auch bedeuten, dass keine Neuaufteilung erfolgt, aber die Reihenfolge, in der die Koordinatenmessgeräte jeweils ihre Oberflächenbereiche vermessen, geändert wird. Es wird aber bevorzugt, wenn diese Aufteilung zumindest einmalig und vorzugsweise mehrmalig im Rahmen des Verfahrens geändert wird.

Bei dem hierfür verwendeten Algorithmus kann es sich um einen Algorithmus handeln, der auf Lösungsansätzen für ein sogenanntes "multiple travelling salesman problem" oder auch eines "vehicle routing problems" beruht, welches beide Unterarten des Problems des Handlungsreisenden sind. Zur Anwendung auf mehrere Koordinatenmessgeräte können zusätzliche zu erfüllende Bedingungen definiert werden, z.B. dass beide Koordinatenmessgeräte (bzw. aus Sicht eines Algorithmus beide "vehicle") nicht gleichzeitig im gleichen Bereich operieren sollten (z.B. um Kollisionen vorzubeugen).

Außerdem kann dann, wenn von bestimmten Tastern oder Messsensoren nur ein Exemplar vorhanden ist, die Route so zu optimieren sein, dass die Koordinatenmessgeräte möglichst wenig bzw. nur möglichst kurz aufeinander warten müssen, bspw. wenn gleichzeitig derselbe Sensor von den Koordinatenmessgeräten für deren aktuelle Messaufgabe verwendet werden müsste.

Weiter kann vorgesehen sein, ein sogenanntes "vehicle routing problem with time window" zu definieren und Lösungs-Algorithmen hierfür einzusetzen. Hierdurch können Messelemente, die voneinander abhängig sind, in kurzem zeitlichem Abstand bzw. innerhalb eines als Bedingung vorgegebenen Zeitfensters ("time window") vermessen werden.

Zusammengefasst betrifft die Offenbarung also auch ein nicht beanspruchtes Verfahren zum Auswählen einer Messreihenfolge für eine Mehrzahl von Koordinatenmessgeräten, mit:
a) Erhalten einer Mehrzahl von Oberflächenbereichen eines Objekts, die hinsichtlich wenigstens einer vorbestimmten Eigenschaft von wenigstens einem (z.B. zunächst beliebigen bzw. gemäß einer festzulegenden Aufteilung) der Koordinatenmessgeräte und mit einem Messsensor des Koordinatenmessgeräts vermessen werden sollen, wobei der Messsensor zum Vermessen eines jeweiligen Oberflächenbereichs in wenigstens einer spezifischen Position und/oder mit wenigstens einer spezifischen Ausrichtung anzuordnen ist;
b) mehrmaliges Ändern einer Messreihenfolge, in der die Oberflächenbereiche vermessen und zwischen den Koordinatenmessgeräten aufgeteilt werden sollen, mit wenigstens einem Algorithmus (optional aber auch mit einem zweiten Algorithmus gemäß jeglicher der vorstehenden Varianten), wobei der Algorithmus im Rahmen einer jeden Änderung jeweils eine geänderte Messreihenfolge samt einer Bewertungsgröße (bzw. einen Wert für diese Bewertungsgröße) für die geänderte Messreihenfolge ermittelt;
c) Auswählen einer der Messreihenfolgen anhand der insgesamt ermittelten (Werte der) Bewertungsgröße(n).

Ebenso betrifft die Offenbarung eine Verwendung von einem Algorithmus, insbesondere einem Algorithmus, der auf Lösungsansätzen des (insbesondere multiplen) Problems des Handlungsreisenden beruht, zum Festlegen einer Aufteilung von zu vermessenden Oberflächenbereichen eines Objekts, sodass ein Anteil hiervon von einem ersten Koordinatenmessgerät und ein anderer Anteil (insbesondere der verbleibende Anteil) von wenigstens einem weiteren Koordinatenmessgerät vermessen wird. Ein Verfahren sieht demnach nach vor, einen Anteil von zu vermessenden Oberflächenbereichen eines Objekts derart aufzuteilen, dass ein Anteil hiervon von einem ersten Koordinatenmessgerät und ein anderer Anteil (insbesondere der verbleibende Anteil) von wenigstens einem weiteren Koordinatenmessgerät vermessen wird, wofür bevorzugt ein Algorithmus der vorstehenden Art eingesetzt wird. Die Koordinatenmessgeräte können das Objekt zumindest teilweise gleichzeitig vermessen. Bei sämtlichen derartigen Varianten können vorstehende und nachstehende Bedingungen zum Definieren einer geeigneten Aufteilung und/oder Messreihenfolge berücksichtigt werden.

Die beanspruchte Erfindung betrifft hingegen ein Verfahren zum Auswählen einer Messreihenfolge für ein Koordinatenmessgerät, mit:
a) Erhalten einer Mehrzahl von Oberflächenbereichen eines Objekts, die hinsichtlich wenigstens einer vorbestimmten Eigenschaft mit einem Messsensor vermessen werden sollen, wobei der Messsensor von dem Koordinatenmessgerät zum Vermessen eines jeweiligen Oberflächenbereichs in wenigstens einer spezifischen Position und/oder mit wenigstens einer spezifischen Ausrichtung anzuordnen ist;
b) mehrmaliges Ändern einer Messreihenfolge, in der die Oberflächenbereiche vermessen werden sollen, mit wenigstens einem Algorithmus (optional aber auch mit einem zweiten Algorithmus gemäß jeglicher der vorstehenden Varianten), wobei der Algorithmus im Rahmen einer jeden Änderung jeweils eine geänderte Messreihenfolge samt einer Bewertungsgröße (bzw. einen Wert für diese Bewertungsgröße) für die geänderte Messreihenfolge ermittelt;
c) Auswählen einer der Messreihenfolgen anhand der insgesamt ermittelten (Werte der) Bewertungsgröße(n).
wobei als eine von einer jeden Messreihenfolge einzuhaltende Bedingung ein (z.B. zeitliches oder Rangfolge-bezogenes) Relativverhältnis wenigstens zweier Oberflächenbereiche vorgegeben ist.

Sämtliche vorstehenden und nachstehenden Erläuterungen, Weiterbildungen,

Alternativen und Ausführungen zu gleichlautenden Merkmalen des nicht beanspruchten, erstgenannten Verfahrens, bei dem keine entsprechende Bedingung zwingend zum Einsatz kommt, treffen auch auf das vorliegende Verfahren gemäß der beanspruchten Erfindung zu, bei dem eine entsprechende Bedingung berücksichtigt wird. Auch kann ein Verfahren, welches eine Bedingung berücksichtigt, mit jeglicher Variante des erstgenannten Verfahrens kombiniert werden, sodass auch ein Verfahren möglich ist, bei dem zwei unterschiedliche Algorithmen vorgesehen sind und zusätzlich eine der hierin erläuterten Bedingungen.

Die Bedingung kann von den Algorithmen beim Ändern der Messreihenfolge berücksichtigt werden. Messreihenfolgen, die die Bedingung verletzen können daher als ungültig bewertet werden und nicht weiter bewertet werden und/oder in Schritt c) nicht auswählbar sein. Es ist aber auch möglich, eine solche Überprüfung mit einer separaten Einheit (zum Beispiel einer Softwareeinheit) durchzuführen, die von den Algorithmen geänderte und bewertete Messreihenfolgen erst nachträglich aussortiert bzw. für ungültig erklärt.

Das Verfahren kann also den Schritt umfassen, dass die Algorithmen unter Berücksichtigen einer entsprechenden Bedingung die Messreihenfolge ändern (also nur gültige geänderte Messreihenfolge erzeugen und/oder bewerten). Ebenso kann aber der Schritt vorgesehen sein, von den Algorithmen geänderte und bewertete Messreihenfolge nachträglich hinsichtlich der einzuhaltenden Bedingung zu überprüfen und ggf. auszusortieren.

Gemäß einer Variante definiert das laut der Bedingung einzuhaltende Relativverhältnis eine relative Reihenfolge (bzw. die Rangfolge) der wenigstens zwei Oberflächenbereiche innerhalb der Messreihenfolge. Es ist vorgegeben, dass einer der Oberflächenbereiche vor einem anderen der Oberflächenbereiche vermessen werden muss, da die Vermessungsergebnisse des einen Oberflächenbereichs die Vermessung des anderen Oberflächenbereichs mitbestimmen und/oder hierzwischen eine Abhängigkeit besteht. Dies trifft zum Beispiel dann zu, wenn ein erster der Oberflächenbereiche ein erstes geometrisches Merkmal umfasst und für den zweiten Oberflächenbereich bestimmt werden soll, inwieweit ein dortiges geometrisches Merkmal in einem vorbestimmten Relativverhältnis zu dem geometrischen Merkmal des ersten Oberflächenbereichs und/oder z.B. hierzu parallel ist. Beispielsweise kann als Messaufgabe die Bestimmung der Parallelität zweier Zylinder vorgegeben sein. In diesem Fall wird der erste Zylinder abgescannt und beim zweiten Zylinder wird bevorzugt nur noch eine Kreisbahn an derjenigen Höhe gemessen, an der der andere Zylinder die größte positive Abweichung z.B. von einem Solldurchmesser hatte. Hierdurch kann einerseits Zeit gespart und können andererseits kritische Stellen besser erfasst werden.

Zusätzlich oder alternativ kann als laut der Bedingung einzuhaltendes Relativverhältnis vorgegeben werden, dass eine maximal zulässige Zeitspanne einzuhalten ist, innerhalb derer die Oberflächenbereiche beim Ausführen der Messreihenfolge vermessen werden dürfen bzw. sollen. Dem liegt der Gedanke zugrunde, dass beim Vermessen der Oberflächenbereiche möglichst gleichartige Bedingungen vorherrschen sollen. Insbesondere kann hierüber sichergestellt werden, dass vergleichbare Temperaturbedingungen vorliegen. Beispielsweise kann als Zeitspanne vorgegeben werden, dass die Messungen zweier Oberflächenbereiche nicht mehr als 1 Minute oder nicht mehr als 5 Minuten auseinanderliegen dürfen.

Als Alternative zu einer das Relativverhältnis betreffenden Bedingung, welche nicht unter den Schutzumfang der gegenwärtigen Erfindung fällt, kann als Bedingung auch eine einzuhaltende Kollisionsfreiheit vorgegeben sein. Dies kann darauf Abstellen, dass zum Bewegen des Messsensors gemäß der Messreihenfolge (d. h. zwischen den laut Messreihenfolge aufeinanderfolgenden Oberflächenbereichen) keine Kollisionen mit dem Objekt oder anderweitige Störkonturen im Arbeitsraum des Koordinatenmessgeräts auftreten sollen. Dies kann durch Berechnen (zum Beispiel per NC-Algorithmus) und/oder Simulieren des Bewegungspfades des Messsensors zwischen den laut Messreihenfolge aufeinanderfolgenden Oberflächenbereichen ermittelt werden, zum Beispiel unter Abgleich mit einem Modell des Objektes und/oder des Arbeitsraums des Koordinatenmessgeräts.

Auch Verfahren, bei denen Bedingungen der vorstehenden Art berücksichtigt werden, können mit einer Computereinrichtung gemäß jeglicher hierin geschilderten Art ausgeführt werden, wobei eine derartige Computereinrichtung ein weiterer allgemeiner Bestandteil der vorliegenden Erfindung ist. Anders ausgedrückt betrifft die Erfindung auch eine Computereinrichtung zum Ausführen von Verfahren, die Bedingungen der vorstehenden Art berücksichtigen.

Einer Prozesseinrichtung der Computereinrichtung kann dazu eingerichtet sein, die entsprechende Bedingung beim Ausführen von Algorithmen zu berücksichtigen und/oder beim Auswählen oder vor dem Auswählen die Messreihenfolge dahingehend zu bewerten, ob sie die Bedingung erfüllen oder nicht. Die Bedingung kann in einer Speichereinrichtung der Computereinrichtung hinterlegt sein. Die Computereinrichtung kann ferner durch Simulationen und/oder Berechnungen überprüfen, ob die Bedingung eingehalten ist. Hierfür kann sie die laut der Messreihenfolge erforderlichen Bewegungen des Messsensors berechnen oder simulieren, die erforderlich sind, damit dieser nach Maßgabe der Messreihenfolge von Oberflächenbereich zu Oberflächenbereich gelangt (d. h. die laut der Messreihenfolge aufeinanderfolgen Oberflächenbereichen vermessen kann).

Allgemein kann die Computereinrichtung von einem Koordinatenmessgerät umfasst oder hiermit verbunden sein und dieses optional nach Maßgabe der und/oder zum Ausführen der ausgewählten Messreihenfolge ansteuern.

Im Folgenden werden Ausführungsbeispiele von Beispielen und der beanspruchten Erfindung anhand der beigefügten schematischen Figuren erläutert. In Ihrer Art und/oder Funktion übereinstimmende Merkmale können dabei figurenübergreifend mit den gleichen Bezugszeichen versehen sein. Es stellen dar:
- Fig. 1:: eine schematische Darstellung eines Objekts und von dessen Oberflächenbereichen, die im Rahmen einer Messreihenfolge von einem Koordinatenmessgerät vermessen werden sollen;
- Fig. 2A-2B:: eine Darstellung möglicher Messreihenfolgen zum Vermessen der Oberflächenbereiche aus Figur 1;
- Fig. 3:: ein Ablaufschema eines beispielhaften Verfahrens gemäß einem ersten Ausführungsbeispiel;
- Fig. 4:: ein Ablaufschema eines beispielhaften Verfahrens gemäß einem zweiten Ausführungsbeispiel;
- Fig. 5:: eine grafische Darstellung erhaltener Werte der Bewertungsgröße beim Ausführen des Verfahrens aus Figur 4; und
- Fig. 6: ein Ablaufschema eines Verfahrens gemäß der beanspruchten Erfindung.

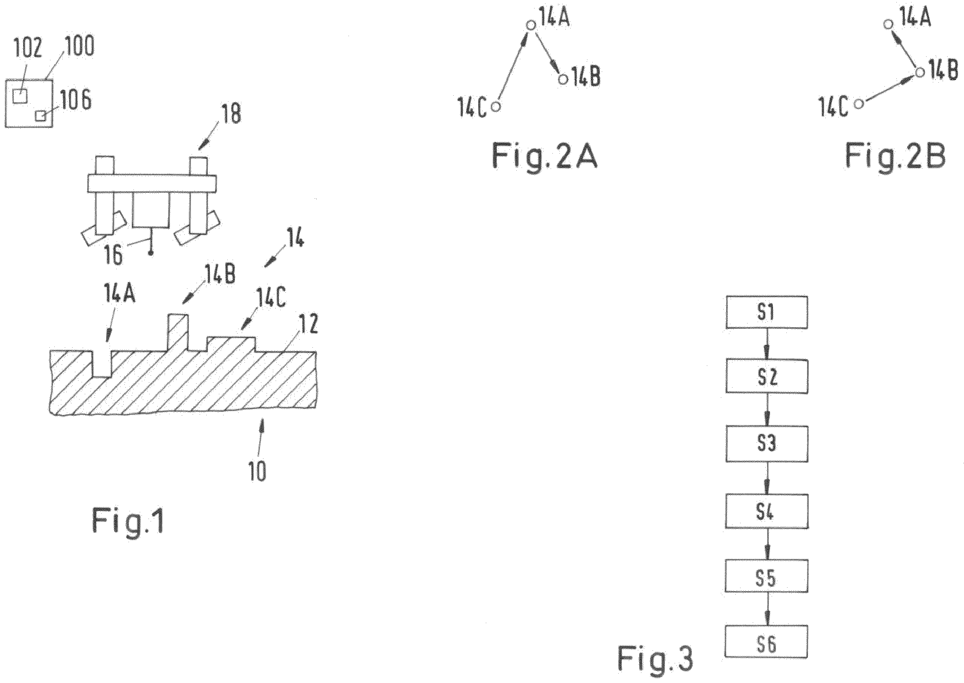

In Figur 1 ist ein Objekt 10 in Form eines industriellen hergestellten Werkstücks in Querschnittsdarstellung gezeigt. Das Objekt 10 weist entlang seiner Oberfläche 12 mehrere zu vermessende Oberflächenbereiche 14 auf, welche sich im gezeigten Fall geometrisch von der verbleibenden und bevorzugt im Wesentlichen ebenen Oberfläche 12 unterscheiden. Bei diesen Oberflächenbereichen 14 handelt es sich um sogenannte Messelemente, welche vorbestimmte geometrische Eigenschaften aufweisen und zum Beispiel von einem Bediener oder automatisch von einer Computereinrichtung 100 jeweils vorzugsweise anhand eines CAD-Modells identifiziert und/oder ausgewählt werden können. Von rechts nach links sind als entsprechend Oberflächenbereiche 14 eine Bohrung 14A, ein Vorsprung 14B und ein Plateau 14C gezeigt.

Für jeden dieser Oberflächenbereiche 14 sind vorbestimmte Eigenschaften vorgegeben, die per Vermessung ermittelt werden sollen. Hierbei handelt es sich um sogenannte Prüfmerkmale. Im Fall der Bohrung 14A kann dies zum Beispiel ein Durchmesser oder eine Tiefe sein, im Fall des Vorsprungs 14B die Höhe und im Fall des Plateaus 14C eine Ebenheit von dessen Oberfläche. Derartige Prüfmerkmale können erneut von einem Bediener oder automatisch von einer Computereinrichtung 100 vorgegeben werden.

Um diese Eigenschaften zu ermitteln, ist ein Messsensor 16 an einem lediglich schematisch angedeuteten und zum Beispiel als herkömmliches und mit drei orthogonal zueinander verlaufenen Maschinenachsen ausgebildeten Koordinatenmessgerät 18 angeordnet. In dem gezeigten Beispiel handelt es sich bei dem Messsensor 16 um einen taktilen Sensor. Es könnte aber auch ein optischer Sensor zum Beispiel in Form einer Kamera verwendet werden.

In an sich bekannter Weise soll dieser Messsensor 16 von dem Koordinatenmessgerät 18 zum Vermessen der gewünschten Eigenschaften der Oberflächenbereiche 14 in wenigstens einer spezifischen Position und/oder mit wenigstens einer spezifischen Ausrichtung je Oberflächenbereich positioniert werden. Beispielsweise kann es zum Erfassen eines Bohrungsdurchmessers erforderlich sein, die Koordinaten von wenigstens drei Punkten am Umfang der Bohrung zu ermitteln, wobei jeder Punkt einer spezifischen einzunehmenden Position in diesem Oberflächenbereich 14 entspricht.

Eine einzunehmende Ausrichtung kann zum Beispiel dann vorgegeben sein, wenn der Messsensor 16 ein optischer Sensor ist und dieser zum Beispiel Bilder der Oberflächenbereiche 14 erfassen soll. Per Bildauswertung können in an sich bekannter Weise aus derartigen Bildern ebenfalls Eigenschaften der vorstehend genannten Art ermittelt werden.

Zusammengefasst muss der Messsensor 16 von dem Koordinatenmessgerät 18 also von Position zu Position bzw. Ausrichtung zu Ausrichtung bewegt werden, welche den jeweiligen Oberflächenbereichen 14 zugeordnet sind. Diese Bewegungen stellen einen nicht wertschöpfenden Zeitverlust innerhalb des Messvorgangs dar, da dabei keine Messinformationen gewonnen werden. Insbesondere beim Vermessen komplexer und/oder zahlreicher Werkstücke oder aber dem Vermessen in einem Fertigungstakt kann es daher gewünscht sein, diesen Zeitverlust möglichst gering zu halten.

Im Folgenden wird lediglich beispielhaft von lediglich einer spezifischen anzunehmenden Position je Oberflächenbereich 14 ausgegangen, in denen der Messsensor 16 anzuordnen ist (also von nur einem Messpunkt). Es versteht sich, dass für jeden Oberflächenbereich 14 auch mehrere derartige spezifische Positionen einzunehmen sein können.

Die im Folgenden lediglich beispielhaft diskutierte einzelne Position je Oberflächenbereich 14 kann eine Start- oder Endposition sein, die der Messsensor 16 zum Ermitteln wenigstens einer vorbestimmten Eigenschaft eines jeweiligen Oberflächenbereichs 14 einzunehmen hat. Insbesondere kann es sich dann, wenn der Oberflächenbereich 14 angefahren werden soll (beispielsweise ausgehend von einem vorangehend vermessenen Oberflächenbereich 14) um eine Startposition und dann, wenn der Oberflächenbereich 14 verlassen werden soll (beispielsweise um einen nachfolgend zu vermessenen Oberflächenbereich 14 anzufahren), um eine Endposition handeln.

Es versteht sich, dass zum Abarbeiten (d. h. zum aufeinanderfolgenden Vermessen) der Oberflächenbereiche 14 aufgrund der Anzahl der Oberflächenbereich 14 mehrere Optionen für entsprechend Messreihenfolge bzw. Sortierungen bestehen. Allgemein gilt für n anzufahrende Oberflächenbereich 14, dass n! mögliche Messreihenfolgen bzw. Sortierungen existieren (bzw. (n-1)! Wenn ein fester Startpunkt vorgegeben ist). Diese können hierin auch als Routen bezeichnet werden.

In den Figuren 2A-B sind zwei ausgewählte Routen gezeigt, wobei die entsprechend Oberflächenbereiche 14 aus Figur 1 mittels der dazugehörigen geometrischen Merkmale 14A-C referenziert sind und, wie vorstehend erläutert, als jeweils wenigstens eine anzufahrende spezifische Position dargestellt sind. Man erkennt, dass man das Plateau 14C aus Ausgangsposition wählen kann und anschließend zunächst die Bohrung 14A und dann den Vorsprung 14B vermessen kann (Figur 2A). Ebenso könnte aber ausgehend von dem Plateau 14C zunächst der Vorsprung 14B und erst anschließend die Bohrung 14A vermessen werden (Figur 2B). Auch könnte statt dem Plateau 14C der Vorsprung 14B oder die Bohrung 14A als Ausgangspunkt und können hiervon ausgehend alternative Routen definiert werden.

Aufgrund von Eigenschaften des Koordinatenmessgeräts 18, des Messsensors 16 und/oder des Objekts 10 kann es zum Beispiel zur Kollisionsvermeidung oder aufgrund des Bewegungsumfangs der Maschinenachsen dabei auch einen Unterschied machen, ob zum Beispiel von dem Plateau 14C zu der Bohrung 14A gefahren wird oder umgekehrt von der Bohrung 14A zu dem Plateau 14C.

Somit stehen also eine Vielzahl von möglichen Messreihenfolgen (bzw. Sortierungen oder Routen) zur Auswahl, die jeweils mit dazugehörigen Bewegungsprofilen des Messsensor 16 einhergehen, um diesen von Messelement zu Messelement (bzw. Oberflächenbereich 14 zu Oberflächenbereich 14) bewegen zu können.

Mittels bekannter TSP-Algorithmen, wie sie von einer Computereinrichtung 100 ausführbar sind, die schematisch in Figur 1 angedeutet ist und die wenigstens einen Mikroprozessor 102 umfasst, kann ermittelt werden, welche der zur Auswahl stehenden Messreihenfolgen hinsichtlich einer aus Sicht des Benutzers relevanten Bewertungsgröße optimal ist.

Hierfür kann die Computereinrichtung 100 über eine Speichereinrichtung 16 verfügen, in der die zu vermessenen Oberflächenbereiche 14 samt hierfür zu bestimmender Eigenschaften hinterlegt sind. Derartige Festlegungen können zum Beispiel durch Benutzereingaben und/oder automatisch durch geeignete Algorithmen ermittelt werden, die ein CAD-Modell des Objekts auswerten.

Die optimale Messreihenfolge kann von der Computereinrichtung 100 automatisch oder in Reaktion auf eine entsprechende Benutzereingabe ausgewählt werden und zur Steuerung des Koordinatenmessgerät 18 verwendet werden, sodass dieses die Messreihenfolge umsetzt. Der Vollständigkeit halber sei erwähnt, dass es sich bei der Computereinrichtung 100 um einen herkömmlichen PC handeln kann. Es kann sich aber ebenso um eine Steuereinrichtung des Koordinatenmessgeräts 18 oder um einen Server (z.B. einen Cloud-Server) handeln.

Die TSP-Algorithmen ändern gemäß darin definierter Regeln sukzessive die Messreihenfolge (d. h. Arbeiten mehrere variierende Messreihenfolge ab und Ermitteln für eine jeweilige Messreihenfolge den Wert der Bewertungsgröße).

In dem vorliegend gezeigten Fall handelt es sich bei der Bewertungsgröße um die insgesamt erforderliche Messzeitdauer, welche maßgeblich durch die erforderlichen Bewegungen zwischen den einzelnen Oberflächenbereichen 14 bestimmt wird. Es kann als Messzeitdauer somit auch nur diese Bewegungsdauer zum Bewegen des Messsensor 16 zwischen den einzelnen Oberflächenbereichen 14 betrachtet werden oder aber die Distanz bzw. das Ausmaß der hierfür erforderlichen Maschinenachsenbewegungen.

Wie nachstehend noch erläutert, können die jeweils ermittelten Bewertungsgrößen dahingehend ausgewertet werden, mit welcher Messreihenfolge ein (lokales oder absolutes) Optimum der Bewertungsgröße und, in den gezeigten Beispielen, ein (lokales oder absolutes) Minimum der Bewertungsgröße erreichbar ist.

Beispielhaft kommen bei den nachfolgend diskutierten Beispielen zwei Algorithmen zum Einsatz. Hierbei handelt es sich bevorzugt jeweils um einen TSP-Algorithmus. Im Folgenden werden verschiedene Möglichkeiten aufgezeigt, wie diese Algorithmen kombiniert und/oder miteinander zusammenwirken können, um eine optimale Messreihenfolge zu ermitteln (d. h. eine Messreihenfolge mit einem optimalen Wert der Bewertungsgröße und insbesondere mit einem minimalen Wert der Bewertungsgröße).

In Figur 3 ist Ablaufschema für ein beispielhaftes Verfahren gemäß einem ersten Ausführungsbeispiel gezeigt. Dabei werden zwei TSP-Algorithmen aufeinanderfolgend ausgeführt, insbesondere derart, dass deren Ausführung sich nicht zeitlich überlappt bzw. dass der zweite TSP-Algorithmus auf Ergebnissen des ersten TSP-Algorithmus aufbaut. In einem Schritt S1 werden die zu vermessenden Oberflächenbereiche 14 vorzugsweise samt hierfür zu ermittelnder Eigenschaften erhalten, z.B. von einem Bediener oder aus der manuellen oder automatischen Auswertung eines CAD-Modells des Objekts 10.

In einem Schritt S2 werden daraufhin für jeden Oberflächenbereich 14 wenigstens eine Position und/oder Ausrichtung ermittelt, die der Messsensor 16 einnehmen muss, um die gewünschten Eigenschaften der Oberflächenbereiche 14 zu ermitteln. Derartige Ermittlungen sind bekannt und werden auch bei derzeit verfügbaren Lösungen eingesetzt. Hierfür können beispielsweise (erwartete) Koordinaten des Objekts 10 und insbesondere von dessen Oberflächenbereichen 14 im Arbeitsraum des Koordinatenmessgerät 18 anhand einer Computersimulation ermittelt werden und können daraufhin die vom Koordinatenmessgerät 18 anzuführenden Positionen und/oder einzustellenden Ausrichtung des Messsensor 16 ermittelt werden.

Es ist zudem bekannt, dass zum Beispiel mittels gängiger NC-Algorithmen auch die anhand der Figuren 2 A-B erläuterten Bewegungen und insbesondere einzelne Maschinenachsenbewegungen des Koordinatenmessgerät 18 zum Bewegen des Messsensors zwischen den unterschiedlichen Oberflächenbereichen 14 ermittelbar sind. Insbesondere können darauf basierend auch erforderliche Bewegungsdistanzen und/oder Bewegungszeitdauern ermittelt werden.

Die hierin vorgestellten Algorithmen richten sich aber primär darauf, eine Messreihenfolge aufzufinden, bei der diese vorzugsweise anderweitig bzw. mittels anderen Algorithmen ermittelten Bewegungen des Messsensors 16 bzw. des Koordinatenmessgeräts 18 gewünschte Eigenschaften besitzen und insbesondere besonders schnell ablaufen. Die Sortierung bzw. Aneinanderreihung der Oberflächenbereiche 14 gemäß einer Messreihenfolge bestimmt nämlich maßgeblich über die Art und das Ausmaß der erforderlichen Bewegungen, die dann aber wiederum mittels anderen Algorithmen (optional aber auch mittels der TSP-Algorithmen selbst) genau beziffert werden können. Die TSP-Algortihmen sind aber in jedem Fall dazu eingerichtet, Werte der Bewertungsgröße zu ermitteln, wobei aber auch auf von anderen Algorithmen ermittelte Informationen zurückgegriffen werden kann.

In einem Schritt S3 wird ein erster (TSP-) Algorithmus ausgeführt, der anhand der im Schritt S2 ermittelten Informationen eine Messreihenfolgen definiert und mehrfach ändert, in der die Oberflächenbereichen 14 vermessen werden sollen. Für jede Messreihenfolge ermittelte der erste Algorithmus dabei eine Bewertungsgröße, welche im vorliegenden Beispiel die erforderliche Messzeitdauer ist.

Hierfür kann der Algorithmus erneut mittels bekannter vorstehend erläuterter Algorithmen zum Beispiel die erforderlichen Maschinen- bzw. Maschinenachsbewegungen berechnen und insbesondere simulieren, um eine aktuell betrachtete Messreihenfolge abarbeiten zu können. Mittels der Simulation kann die Zeitdauer der erforderlichen Maschinenachsbewegungen gemessen werden. Alternativ kann diese Zeitdauer zum Beispiel in Kenntnis einer Antriebsleistung sowie des Ausmaßes bzw. der zurückgelegten Distanz der Maschinenachsbewegungen berechnet werden.

In einem Schritt S4 werden die insgesamt ermittelten Bewertungsgrößen betrachtet und wird eine optimale hiervon ausgewählt. Dabei handelt es sich in dem gezeigten Beispiel um die kleinste Bewertungsgröße, d. h. die kürzeste erforderliche Messzeitdauer. In einem Schritt S5 wird dann die dazugehörige Messreihenfolge ausgewählt und als Ausgangsreihenfolge bzw. Initialroute oder auch als Ausgangsgröße für einen zweiten (TSP-) Algorithmus gewählt.

Dieser beginnt in Schritt S6 ausgehend von dieser Initialroute und gemäß durch den Algorithmus festgelegten Regeln, diese initiale Messreihenfolge sukzessive derart zu ändern, dass sich mit einer gewissen Wahrscheinlichkeit weitere Verbesserungen der Bewertungsgröße einstellen. Dies ist beispielsweise dann relevant, wenn mit dem ersten Algorithmus zwar bereits ein lokales Optimum der Bewertungsgröße aufgefunden wurde, nicht aber ein absolutes Optimum, da sich der erste Algorithmus unter Umständen nicht von selbst aus einem lokalen Optimum befreien kann (d. h dieses nicht unter Inkaufnahme einer temporären Verschlechterung wieder verlassen kann, da dies mit den im Algorithmus hinterlegten Regeln zur Änderung der Messreihenfolge unvereinbar ist).

Auch ist es möglich, dass der erste Algorithmus zwar ein aus seiner Sicht Optimum der Bewertungsgröße aufgefunden hat, dass tatsächliche absolute Optimum aber noch nicht erreicht wurde, da hierfür gegebenenfalls auch nur geringe weitere Änderungen der Messreihenfolge erforderlich sind. Anders ausgedrückt können Änderungsschrittweiten oder Änderungsausmaße des ersten Algorithmus vergleichsweise grob oder nicht ausreichend feinauflösend sein, sodass dieser ein tatsächliches Optimum der Bewertungsgröße gegebenenfalls überspringt.

Der zweite Algorithmus kann deshalb in Schritt S6 ausgehend von der bereits als besonders geeignet bewerteten Initialroute weitere Änderungen der Messreihenfolge vornehmen und somit die Wahrscheinlichkeit erhöhen, dass das tatsächliche absolute Optimum aufgefunden wird.

In dem gezeigten Beispiel werden dabei Algorithmen unterschiedlicher Art und insbesondere mit unterschiedlichen Eigenschaften miteinander kombiniert. Der erste Algorithmus ist ein Nearest-Neighbor-Algorithmus und der zweite Algorithmus umfasst eine Metaheuristik, wie dies jeweils im vorstehenden allgemeinen Beschreibungsteil diskutiert wurde.

Allgemein formuliert zeichnet sich der erste Algorithmus durch eine im Vergleich höhere Rechengeschwindigkeit aus, da er schneller zum einem aus seiner Sicht Optimum der Bewertungsgröße gelangt. Hingegen kann sich der erste Algorithmus unter Umständen nicht aus einem lokalen Optimum (insbesondere einem lokalen Minimum) befreien und/oder nicht erkennen, ob es sich bei dem erzielten Optimum um ein lokales oder absolutes Optimum handelt. Der im Vergleich langsamere zweite Algorithmus ist Dank der Metaheuristik hingegen derart definiert, dass er sich aus lokalen Optima und insbesondere einem lokalen Minimum befreien kann und folglich erhöhte Chancen besitzt, ein absolutes Optimum nach Erreichen des lokalen Optimums noch zu erreichen.

Somit ergibt sich durch die beim Ausführungsbeispiel der Figur 3 vorgesehene Kombination unterschiedlicher Algorithmen die Möglichkeit, dass das absolute Optimum vergleichsweise schnell aufgefunden wird. Es ist zum Beispiel möglich, dass der erste Algorithmus das absolute Optimum direkt ermittelt, was dann von dem zweiten Algorithmus bestätigt werden kann, oder dass der erste Algorithmus ein nahe zu diesem absoluten Optimum liegendes lokales Optimum ermittelt hat, sodass der zweite Algorithmus nur noch wenige Änderungen braucht, um zu dem tatsächlichen absoluten Optimum zu gelangen. Dies kann insbesondere im Vergleich zu einem Fall schneller sein, bei dem der zweite Algorithmus von vornherein von einer beliebigen Route bzw. Initialroute ausgeht und somit unter Umständen viele Änderungen und eine lange Berechnungszeit benötigt, um zu dem absoluten Optimum zu gelangen. Der erste Algorithmus kann auch eine vorgegebene maximale Anzahl von Iterationen bzw. Messreihenfolge-Variationen durchführen und beim Erreichen dieser Anzahl das bisher beste Zwischenergebnis als initiale Messreihenfolge an den zweiten Algorithmus ausgeben.

Anhand der Figuren 4 und 5 wird im Folgenden ein beispielhaftes Verfahren gemäß einem weiteren

Ausführungsbeispiel geschildert. In diesem Fall werden zwei (TSP-) Algorithmen zeitlich überlappend ausgeführt und vorzugsweise auch gleichzeitig gestartet. Die Algorithmen sind dabei gleichartig, könnten prinzipiell aber auch verschiedenartig sein. In jedem Fall gehen die Algorithmen von unterschiedlichen Initialrouten aus (d. h. von unterschiedlichen initialen Messreihenfolgen). Ausgehend von ihrer Initialroute führen sie dann gemäß den im Algorithmus hinterlegten Regeln Änderungen der Messreihenfolge durch, um die Bewertungsgröße (in dem gezeigten Beispiel erneut die benötigte Messzeitdauer) zu minimieren.

In einem Schritt S1 werden die beiden Algorithmen ausgewählt. Bevorzugt handelt es sich in beiden Fällen um Algorithmen mit Metaheuristiken und/oder allgemein um Algorithmen, die dazu eingerichtet sind, sich aus lokalen Optima zu befreien (d. h. mit einer hohen Wahrscheinlichkeit noch ein weiteres Optimum auffinden können, wenn bereits ein zumindest lokales Optimum aufgefunden wurde).

In einem Schritt S2 wird eine initiale Messreihenfolge erhalten oder bestimmt, wobei diese jedoch zum Beispiel mittels einer Zufallsvariable für jeden der Algorithmen geändert wird, sodass diese von unterschiedlichen (geänderten) initialen Messreihenfolge ausgehen. Anders ausgedrückt erhalten die Algorithmen jeweils zufällig oder deterministisch verrauschte initiale Messreihenfolgen, sodass sich die initialen Messreihenfolgen der Algorithmen voneinander unterscheiden.

Als deterministisch kann ein Vorgehen bezeichnet werden, das keine Zufallswerte beinhaltet oder auf solchen beruht. Beispielsweise können wenigstens zwei Oberflächenbereiche innerhalb einer Messreihenfolge gemäß einer definierten Vorschrift vertauscht werden, sofern dabei etwaige Bedingungen wie bspw. nachstehend erläuterte Abhängigkeiten erfüllt bleiben.

Hierfür kann z.B. in Abhängigkeit einer Gesamtanzahl von Oberflächenbereichen eine Abfolge berechnet werden, gemäß derer die Oberflächenbereiche als initiale Messreihenfolge aneinandergereiht werden sollen. Genauer gesagt können die Oberflächenbereiche indexiert werden und kann auf Basis der Gesamtanzahl von Oberflächenbereichen und/oder einer festgelegten Zahl maximaler Variationen der Messreihenfolge dann eine Neuindexierung erfolgen, gemäß derer die initiale Messreihenfolge festgelegt wird.

So kann z.B. für den ersten Oberflächenbereich der neu indexierten Messreihenfolge der Oberflächenbereich mit (bisherigem) Index 0 gewählt werden. Als zweiter Oberflächenbereich kann der Oberflächenbereich mit dem (bisherigem) Index gewählt werden, der der Hälfte der insgesamt betrachteten Anzahl von Oberflächenbereichen entspricht. Für die weitere Reihung der Oberflächenbereiche können dann ähnliche Regeln aufgestellt werden, bevorzugt derart, dass kein Oberflächenbereich doppelt in der neu indexierten Messreihenfolge vorhanden ist. Jeder Algorithmus sollte jedoch zumindest abweichend geringfügig vorgehen, sodass unterschiedlich verrauschte Initialrouten erhalten werden.

Im Schritt S3 beginnen die Algorithmen in üblicher Weise, ihre jeweiligen initialen Messreihenfolgen sukzessive gemäß den im Algorithmus hinterlegten Regeln zu ändern und für jede geänderte Messreihenfolge einen Wert der Bewertungsgröße (Messzeitdauer) zu bestimmen.

Dies verdeutlicht sich ferner aus Figur 5, in der die über die Population der insgesamt möglichen Messreihenfolgen (wie vorstehend gezeigt n! mögliche Messreihenfolgen bei n Oberflächenbereichen 14) ein für jede Messreihenfolge erhaltene Wert der Bewertungsgröße aufgetragen ist. Bei dieser Darstellung sind die Messreihenfolgen bevorzugt derart entlang der horizontalen Achse eingetragen, dass diese zu jeder benachbart eingetragenen Messreihenfolge (also zu einer vorigen als auch zu einer anschließenden) nur eine Vertauschung aufweist. Anders ausgedrückt kann nur ein Paar der Oberflächenbereiche 14 in vertauschter Reihenfolge gegenüber den jeweils benachbarten Messreihenfolgen enthalten sein. Für eine beispielhafte Gruppe von Oberflächenbereiche A, B, C könnte gemäß dieser Vorschrift folgende Abfolge von Reihenfolgen entlang der horizontalen Achse eingetragen werden: ABC; ACB; BAC; BCA; CAB; CBA.

Aufgrund der unterschiedlichen initialen Messreihenfolgen gehen die Algorithmen jedoch von unterschiedlichen Startpunkten innerhalb der Population der Messreihenfolgen aus, wie dies durch strichlierte vertikale Linien angedeutet ist.

Genauer gesagt geht ein erster Algorithmus von der mit 2 bezeichneten Messreihenfolge aus und der zweite Algorithmus von der mit 6 bezeichneten Messreihenfolge. Es versteht sich, dass auch noch weitere Algorithmen vorzugsweise gleichzeitig gestartet werden könnten, die dann von weiteren Messreihenfolgen ausgehen.

Aus dem Verlauf der Werte der Bewertungsgröße erkennt man, dass diese bei der Messreihenfolge 2 ein (in dem abgebildeten Ausschnitt) absolutes Maximum aufweist, bei der Messreihenfolge 4 ein lokales Minimum, bei der Messreihenfolge 5 ein lokales Maximum und bei der Messreihenfolge 7 ein absolutes Minimum.

Hieraus verdeutlicht sich auch das vorstehend erläuterte Problem, wonach manche Algorithmen sich aus einem lokalen Optimum nicht mehr befreien können bzw. nicht in der Lage sind, ausgehend hiervon ein noch ein weiteres lokales oder gegebenenfalls sogar absolutes Optimum aufzufinden: Wurde bei der Messreihenfolge 4 ein lokales Minimum ermittelt, würde eine nicht ausreichend große Änderung der Messreihenfolge dazu führen, dass die Bewertungsgröße wieder ansteigt. Dies kann mit den Regeln des Algorithmus unvereinbar sein und/oder ein Abbruchkriterium darstellen, sodass dieser die Messreihenfolge 4 als aus seiner Sicht beste Messreihenfolge ermitteln und dass absolute Minimum bei der Messreihenfolge 7 nicht mehr auffinden würde.

Zurückkommend auf das Ausführungsbeispiel erkennt man, dass der Algorithmus der von der Messreihenfolge 6 ausgeht sich bereits nahe zu der optimalen Messreihenfolge 7 befindet. Es sind daher voraussichtlich nur wenige Änderungen erforderlich, bis dieser Algorithmus diese Messreihenfolge 7 tatsächlich als absolutes Optimum ermittelt hat. Dies gilt insbesondere im Vergleich zu demjenigen Algorithmus, der von der Messreihenfolge 2 ausgeht und der umfangreiche Änderungen benötigen würde, um zu der Messreihenfolge 7 zu gelangen. Insbesondere müsste hierfür das lokale Minimum bei Messreihenfolge 4 überwunden werden.

Sobald einer der Algorithmen ein Optimum aufgefunden hat und ein vorbestimmtes Abbruchkriterium erfüllt, für das im allgemeinen Beschreibungsteil ein geeignetes Beispiel erläutert wurde, kann dies in Schritt S4 zur Beendigung des Verfahrens führen und zur Auswahl der Messreihenfolge mit der bisher besten (da z.B. minimalsten) Bewertungsgröße.

Sämtliche Ausführungsbeispiele sind auch für Varianten einsetzbar, bei denen ein Objekt 10 mit einer Mehrzahl von Koordinatenmessgeräten 18 und Messsensoren 16 vermessen wird. Beispielsweise können zwei Koordinatenmessgeräte 18 beidseitig von einem Objekt 10 angeordnet sein und dieses gleichzeitig mit jeweils einem Messsensor 16 vermessen. Es ist in diesem Zusammenhang bekannt, Messelemente bzw. Oberflächenbereiche 14 zwischen den Koordinatenmessgeräten 18 aufzuteilen, sodass jedes Koordinatenmessgerät 18 eine bestimmte Gruppe von Messelementen des Objekts 10 hinsichtlich relevanter Prüfmerkmale vermisst. Diese Aufteilung erfolgt jedoch bisher manuell und erfordert Erfahrung.

Gemäß einer weiteren Ausführungsform kann demnach vorgesehen sein, mittels wenigstens eines, bevorzugt aber mittels wenigstens zwei TSP-Algorithmen, die z.B. gemäß einem der hierin geschilderten Varianten kombiniert werden, eine optimale Messreihenfolge auch in der Hinsicht auszuwählen und festzulegen, dass die Oberflächenbereiche 14 von unterschiedlichen Koordinatenmessgeräten 18 und/oder Messsensoren 16 vermessen werden, also optimal zwischen den Koordinatenmessgeräten 18 aufgeteilt werden. Auch in diesem Fall kann es wiederum bevorzugt sein, dass Bewegungen zwischen den zu vermessenden Oberflächenbereichen 14 möglichst gering ausfallen. Eine solche Aufteilung kann mit Algorithmen zum Lösen eines sogenannten "multiple travelling salesman problem" oder aber eines "vehicle routing problems" gelingen, welche beide Unterarten des Problems des Handlungsreisenden sind.

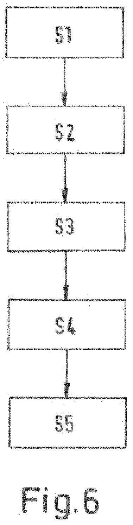

In Figur 6 ist ein Ablaufschema für ein Verfahren gemäß der beanspruchten Erfindung gezeigt. Bei diesem Verfahren kommen nicht zwingend wenigstens zwei Algorithmen zum Einsatz, was aber ebenso vorgesehen sein kann. Kommen wenigstens zwei Algorithmen zum Einsatz, kann dies gemäß jeglicher der hierin geschilderten Varianten und Ausführungsformen erfolgen. Andererseits wird bei der Ausführungsform von Figur 6 wenigstens eine Bedingung berücksichtigt, die die Messreihenfolge einzuhalten haben, damit diese schlussendlich als vom Koordinatenmessgerät auszuführende Messreihenfolge ausgewählt werden können. Analog zu dem vorigen Ausführungsbeispiel werden im Schritt S1 die zu vermessenden Oberflächenbereiche 14 eines Objekts 10 erhalten. In einem Schritt S2 wird dann mit dem wenigstens einen Algorithmus eine Messreihenfolge bestimmt und diese mehrfach geändert, wobei bei jeder Änderung eine geänderte Messreihenfolge samt dazugehöriger Bewertungsgröße ermittelt wird. Dies erfolgt wiederum analog zu den vorigen Ausführungsbeispielen.

In einem Schritt S3 werden aus den insgesamt ermittelten und bewerteten Messreihenfolgen dann nur diejenigen vorausgewählt, welche eine vorbestimmte Bedingung erfüllen. Im Schritt S4 erfolgt dann die schlussendliche Auswahl derjenigen Messreihenfolge, die im vorangehenden Schritt S3 als gültig (d. h. die Bedingung erfüllend) ermittelt wurde und welche die zum Beispiel minimale oder maximale Bewertungsgröße aufweist. Diese kann dann im optionalen Schritt S5 von dem Koordinatenmessgerät 18 zum Vermessen des Objekts 10 umgesetzt werden.

Die Bedingung kann aber auch unmittelbar beim Ändern der Messreihenfolge berücksichtigt werden. Beispielsweise können nur diejenigen Messreihenfolgen von dem Algorithmus tatsächlich bewertet oder anderweitig weiterverfolgt werden, welche die Bedingung erfüllen. Insbesondere kann direkt bei einem Ändern der Messreihenfolge überprüft werden, ob eine angedachte Änderung zu einer die Bedingung erfüllenden Messreihenfolge führt. Wenn dies nicht der Fall ist, kann diese Messreihenfolge nicht erzeugt, abgespeichert, bewertet oder anderweitig weiterverarbeitet werden.

Beispiele für entsprechende Bedingungen sind im allgemeinen Beschreibungsteil genannt. Gemäß eines Beispiels, welches nicht unter den Schutzumfang der beanspruchten Erfindung fällt, kann es sich um das Einhalten einer Kollisionsfreiheit handeln. Gemäß der Erfindung handelt es sich hierbei aber um das Einhalten eines vorbestimmten Relativverhältnisses von Oberflächenbereichen.

Dieses Relativverhältnis kann allgemein zeitlich sein (d. h. zwei Oberflächenbereiche dürfen nur innerhalb einer vorbestimmten maximalen Zeitspanne vermessen werden, d. h. nicht außerhalb dieser vorgegebenen Zeitspanne vermessen werden). Zusätzlich oder alternativ kann das Relativverhältnis eine einzuhaltende (Vermessungs-) Abfolge der Oberflächenbereiche definieren, beispielsweise wenn einer der Oberflächenbereiche vor dem andern vermessen werden muss, da eine zu bestimmende Eigenschaft des anderen Oberflächenbereichs von einer zu bestimmenden Eigenschaft des ersten Oberflächenbereichs abhängt.

## Patentansprüche

1. Verfahren zum Auswählen einer Messreihenfolge für wenigstens ein Koordinatenmessgerät (18), mit:
a) Erhalten einer Mehrzahl von Oberflächenbereichen (14) eines Objekts (10), die hinsichtlich wenigstens einer vorbestimmten Eigenschaft mit wenigstens einem Messsensor (16) vermessen werden sollen, wobei der Messsensor (16) von dem Koordinatenmessgerät (18) zum Vermessen eines jeweiligen Oberflächenbereichs (14) in wenigstens einer spezifischen Position und/oder mit wenigstens einer spezifischen Ausrichtung anzuordnen ist;
und **gekennzeichnet, durch**
b) mehrmaliges Ändern einer Messreihenfolge, in der die Oberflächenbereiche (14) vermessen werden sollen, mit wenigstens einem Algorithmus, wobei der Algorithmus im Rahmen einer jeden Änderung jeweils eine geänderte Messreihenfolge samt einer Bewertungsgröße für die geänderte Messreihenfolge ermittelt;
c) Auswählen einer der Messreihenfolgen anhand der ermittelten Bewertungsgrößen;
wobei als eine von einer jeden Messreihenfolge einzuhaltende Bedingung ein Relativverhältnis wenigstens zweier Oberflächenbereiche (14) vorgegeben ist,
**dadurch gekennzeichnet, dass**
das Relativverhältnis eine maximal zulässige Zeitspanne angibt, innerhalb derer die wenigstens zwei Oberflächenbereiche (14) beim Ausführen der Messreihenfolge vermessen werden dürfen
und/oder
das Relativverhältnis eine relative Reihenfolge der wenigstens zwei Oberflächenbereiche (14) innerhalb der Messreihenfolge angibt, wobei vorgegeben ist oder vorgegeben wird, dass einer der wenigstens zwei Oberflächenbereiche vor einem anderen der wenigstens zwei Oberflächenbereiche vermessen werden muss, da die Vermessungsergebnisse des einen der wenigstens zwei Oberflächenbereiche die Vermessung des anderen der wenigstens zwei Oberflächenbereiche mitbestimmen und/oder hierzwischen eine Abhängigkeit besteht.

2. Computereinrichtung (100), die dazu eingerichtet ist, eine Messreihenfolge für ein Koordinatenmessgerät durch Ausführen eines Verfahrens gemäß Anspruch 1 festzulegen.

## Claims

1. Method for selecting a measurement sequence for at least one coordinate measuring machine (18), including:
a) obtaining a plurality of surface regions (14) of an object (10) that should be measured by at least one measurement sensor (16) in respect of at least one predetermined property, wherein the measurement sensor (16) should be arranged by the coordinate measuring machine (18) at at least one specific position and/or with at least one specific alignment for the purpose of measuring a respective surface region (14);
and being **characterized by**
b) changing a measurement sequence, in which the surface regions (14) should be measured, multiple times using at least one algorithm, wherein the algorithm in each case ascertains a changed measurement sequence and an assessment variable for the changed measurement sequence within the scope of each change;
c) selecting one of the measurement sequences on the basis of the ascertained assessment variables;
wherein a relative relationship of at least two surface regions (14) is specified as a condition to be observed by each measurement sequence,
**characterized in that** the relative relationship specifies a maximum admissible time interval, within which the at least two surface regions (14) are allowed to be measured when carrying out the measurement sequence
and/or
the relative relationship specifies a relative sequence of the at least two surface regions (14) within the measurement sequence, wherein it is specified that one of the at least two surface regions must be measured before another surface region of the at least two surface regions, since the measurement results of the one surface region of the at least two surface regions co-determine the measurement of the other surface region of the at least two surface regions and/or there is a dependency therebetween.

2. Computer device (100), configured to set a measurement sequence for a coordinate measuring machine by carrying out a method according to Claim 1.

## Revendications

1. Procédé de sélection d'une séquence de mesure pour au moins un appareil de mesure de coordonnées (18), comprenant :
a) l'obtention d'une pluralité de zones de surface (14) d'un objet (10), qui doivent être mesurées en ce qui concerne au moins une propriété prédéfinie à l'aide d'au moins un capteur de mesure (16), le capteur de mesure (16) devant être disposé par l'appareil de mesure de coordonnées (18) dans au moins une position spécifique et/ou dans au moins une orientation spécifique pour mesurer une zone de surface (14) respective ;
et **caractérisé par**
b) la modification répétée d'une séquence de mesure dans laquelle les zones de surface (14) doivent être mesurées, à l'aide d'au moins un algorithme, l'algorithme déterminant, dans le cadre de chaque modification, une séquence de mesure modifiée ainsi qu'une grandeur d'évaluation pour la séquence de mesure modifiée ;
c) la sélection de l'une des séquences de mesure sur la base des grandeurs d'évaluation déterminées ;
une relation relative d'au moins deux zones de surface (14) étant prédéfinie en tant que condition devant être respectée par chaque séquence de mesure,
**caractérisé en ce que** la relation relative indique une durée maximale admissible au cours de laquelle lesdites au moins deux zones de surface (14) peuvent être mesurées lors de l'exécution de la séquence de mesure
et/ou
**en ce que** la relation relative indique un ordre relatif desdites au moins deux zones de surface (14) au sein de la séquence de mesure, le fait que l'une desdites au moins deux zones de surface doit être mesurée avant une autre desdites au moins deux zones de surface étant prédéfini ou devant être prédéfini, sachant que les résultats de mesure de l'une desdites au moins deux zones de surface déterminent en partie la mesure de l'autre desdites au moins deux zones de surface et/ou qu'une dépendance existe entre celles-ci.

2. Dispositif informatique (100) qui est conçu pour définir une séquence de mesure pour un appareil de mesure de coordonnées par mise en œuvre d'un procédé selon la revendication 1.
